(19) **Europäisches Patentamt / European Patent Office / Office européen des brevets**

(11) **EP 4 716 441 A1**

(12) # EUROPEAN PATENT APPLICATION

(43) Date of publication:
25.03.2026 Bulletin 2026/13

(21) Application number: 25190435.5

(22) Date of filing: 18.07.2025

(51) International Patent Classification (IPC):
$H10P\ 72/00^{(2026.01)}$ $H10P\ 72/30^{(2026.01)}$

(52) Cooperative Patent Classification (CPC):
H10P 72/3402; H10P 72/0456; H10P 72/0458;
H10P 72/0606; H10P 72/3302; H10P 72/3306;
H10P 72/53; H10P 72/7602; H10P 72/7612

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
GE KH LA MA MD TN

(30) Priority: 18.09.2024 JP 2024160949

(71) Applicant: SCREEN Holdings Co., Ltd.
Kyoto-shi, Kyoto 602-8585 (JP)

(72) Inventor: KUWAHARA, Joji
Kyoto, 602-8585 (JP)

(74) Representative: Kilian Kilian & Partner mbB
Zielstattstraße 23a
81379 München (DE)

(54) **SUBSTRATE CONVEYANCE APPARATUS AND POSITION TEACHING METHOD**

(57) An imaging unit 55 captures an image of a hand unit 43 at a reference position Bs and an image of the hand unit 43 at an advanced position Cs where the hand unit 43 has advanced from the reference position Bs by an advanced amount P1. A position calculation unit 73 calculates an estimated moving amount L1 of the hand unit 43 from each image. A correction coefficient calculation unit 74 calculates a correction coefficient Mk based on the advanced amount P1 and the estimated moving amount L1. A calibration unit 75 calculates a calibrated moving amount H by calibrating a necessary moving amount E calculated based on an image of a conveyance target object with the correction coefficient Mk. Since the calibration unit 75 calibrates a difference between the advanced amount P1 and the estimated moving amount L1, the difference caused by the imaging unit 55 and optical images 81,82 can be eliminated in a configuration in which a position of a conveyance destination using optical images 81,82 captured by the imaging unit 55.

Fig.6

**Description**

BACKGROUND

Technical Field

The present invention relates to a substrate conveyance apparatus and a position teaching method for teaching a position of a conveyance destination to a substrate conveyance apparatus. The substrate conveyance apparatus conveys a substrate such as a semiconductor wafer (hereinafter, referred to as "wafer"), a glass substrate for a photomask, or a substrate for an optical disk to the conveyance destination.

Related Art

As an example of a substrate processing apparatus that performs a series of processing on a substrate, there is an apparatus that exposes a substrate on which a resist film is formed with a separate exposure device and performs development processing on the exposed substrate. The apparatus includes thereinside a plurality of blocks such as an indexer block that loads a carrier accommodating a substrate into the apparatus, a coating processing block that performs coating processing for resist film formation on the substrate, and a development processing block that performs development processing on the substrate. Each of the blocks is partitioned by a partition wall, as an example.

A stage for placing the substrate is disposed on each partition wall. Each block is provided with a substrate conveyance apparatus for conveying the substrate. A substrate conveyance apparatus disposed in one block places the substrate onto the stage, and a substrate conveyance apparatus disposed in an adjacent block holds the substrate, thus the substrate is delivered and conveyed between the two substrate conveyance apparatuses. Each of the blocks includes a processing table to place the substrate to perform various types of processing, and the substrate conveyance apparatus conveys the substrate to place the substrate onto the processing table. The substrate processing apparatus performs processing on a large number of substrates. Thus, in the substrate processing apparatus, a large number of placement units, such as the stage and the processing table, are disposed as a conveyance destination for conveying the substrates.

In such a substrate processing apparatus, a position where the substrate conveyance apparatus places the substrate with respect to the placement unit is set as a target position of a substrate conveyance mechanism. In the substrate processing apparatus, the target position in calculation is calculated in advance according to each dimension of design drawing or the like. That is, ideally, by moving the substrate conveyance apparatus to the target position in calculation, the substrate should be placed at an accurate position with respect to the placement unit. However, the position (actual target position) of the substrate conveyance apparatus at which the substrate can be actually placed at an accurate position with respect to the placement unit may deviate from the target position in calculation. The actual target position deviates from the calculation target position because of an assembly error when the apparatus is assembled, wear of various components in the substrate conveyance apparatus, or the like.

To eliminate such a deviation of the actual target position from the target position in calculation, it is necessary to teach the actual target position to the substrate conveyance apparatus for each of a large number of placement units included in the substrate processing apparatus. The work of correcting the positional deviation by teaching the actual target position to the substrate conveyance apparatus is also called teaching work (teaching). Teaching is performed at the time of start-up or maintenance of the substrate processing apparatus.

Conventionally, when teaching the actual target position to a substrate conveyance apparatus, an operator visually confirms the actual target position and moves the substrate conveyance apparatus to the actual target position through manual operation. Such teaching through manual operation puts a heavy burden on the operator. In addition, depending on the skill level of the operator, there is also a concern that the work may be prolonged or a teaching error may occur.

Thus, in recent years, attempts have been made to automate the teaching. As an example of a configuration for automating the teaching, a configuration using a substrate conveyance apparatus in which a camera is disposed at a base end of a hand portion that holds a substrate has been proposed (see, for example, JP 2023-177092 A). In the configuration according to JP 2023-177092 A, the operator places a simulated substrate on a placement unit and photographs the simulated substrate with a camera disposed in the substrate conveyance apparatus, thereby automating the work of teaching a target position.

As another example of the configuration for automating the teaching, a configuration using a substrate conveyance apparatus on which a camera is mounted and a teaching jig including a plurality of detection points has been proposed (see, for example, JP 2024-058215 A). In the configuration according to JP 2024-058215 A, the detection point of the teaching jig placed on the placement unit is photographed by the camera mounted on the hand portion holding the substrate, whereby the shift amount between the current position and the target position of the substrate conveyance apparatus is calculated. The work of teaching the target position is automated by calculating the operation amount of the substrate conveyance apparatus based on the shift amount.

SUMMARY

However, the conventional example having such a configuration has the following problems. That is, in both the teaching work disclosed in JP 2023-177092 A and JP 2024-058215 A, automation of the work is insufficient. That is, in the teaching work according to JP 2023-177092 A, it is necessary for the operator to place the simulated substrate onto the placement unit, and thus it is difficult to automate the entire teaching work. In the teaching work according to JP 2024-058215 A, it is also necessary for the operator to place the teaching jig onto the placement unit, and thus it is difficult to automate the entire teaching work.

The teaching works disclosed in JP 2023-177092 A and JP 2024-058215 A require a member dedicated to the teaching work, for example, the simulated substrate or the teaching jig. Thus, the configuration required for the teaching work becomes complicated, and the number of steps required for the teaching work increases.

Further, in the configurations disclosed in JP 2023-177092 A and JP 2024-058215 A, it is difficult to eliminate the deviation of the actual target position from the target position in calculation. In the teaching work disclosed in JP 2023-177092 A, JP 2024-058215 A, and the like, a direction and a distance in which the hand portion is moved are calculated in order for the substrate conveyance apparatus to move to an actual target position based on an image taken by a camera. As an example, it is assumed that it is calculated through the teaching work that the substrate conveyance apparatus can be moved to the target position by moving the distance of a predetermined value L1 in a direction A.

However, as a result of intensive studies by the inventors of the present invention, it has been found that even when a control unit of the substrate processing apparatus transmits a control signal to the substrate conveyance apparatus to move the hand portion in the direction A so that the movement distance has the predetermined value L1, the value of the movement distance of the hand portion calculated based on the image taken by the camera is different from the predetermined value L1 in some cases. In such a conventional configuration in which the actual target position is set using an image obtained by capturing a simulated conveyance destination or the like placed on the placement unit, it is difficult to grasp the difference between the moving distance of the hand portion instructed by the control unit and the value calculated as the moving distance of the hand portion from the image of the camera. As a result, it is difficult to improve the accuracy of the teaching work with the conventional configuration.

The present invention has been made in view of such circumstances, and an object thereof is to provide a substrate conveyance apparatus and a position teaching method capable of automating a teaching operation with a simpler configuration.

To achieve such an object, the present invention has the following configurations.

That is, the present invention is a substrate conveyance apparatus that conveys a substrate to a conveyance target object, the substrate conveyance apparatus including:

a substrate holding unit movable in a first direction while holding a substrate;
a movable table that holds the substrate holding unit and is movable at least in a second direction different from the first direction;
a pair of imaging units disposed on the movable table at a predetermined interval and configured to capture an image of a region including the substrate holding unit and a space in front of the substrate holding unit;
an advance/retraction drive unit drive unit that drives the substrate holding unit to advance or retract in the first direction;
a drive control unit that transmits information on a drive distance in the first direction to the advance/retraction drive unit to control an operation of the advance/retraction drive unit;
a reference image acquisition unit that acquires a reference image by capturing an image of the substrate holding unit disposed at a reference position in the substrate conveyance apparatus with the pair of imaging units;
an advanced image acquisition unit that acquires an advanced image by capturing, with the pair of imaging units, an image of the substrate holding unit advanced from the reference position in the first direction by a predetermined advancing amount by the drive control unit;
a target object image acquisition unit that acquires a target image by capturing an image of the conveyance target object with the pair of imaging units;
a reference position calculation unit that calculates a position of the substrate holding unit with respect to the pair of imaging units as reference positional information based on the reference image;
an advanced position calculation unit that calculates a position of the substrate holding unit with respect to the pair of imaging units as advanced positional information based on the advanced image;
a target object position calculation unit that calculates a position of the conveyance target object with respect to the pair of imaging units as target object positional information based on the target object image;
an estimated moving amount calculation unit that calculates an estimated moving amount that is a distance by which the substrate holding unit is estimated to have moved from the reference position to the advanced position based on the reference positional information and the advanced positional information;

a correction coefficient calculation unit that calculates a correction coefficient for correcting a difference between the estimated moving amount and the advancing amount by using the estimated moving amount and the advancing amount;

a calibration unit that acquires corrected positional information by calibrating the target object positional information using the correction coefficient; and

a position storage unit that stores the corrected positional information acquired by the calibration unit,

wherein the pair of imaging units move with movement of the movable table but do not move with movement of the substrate holding unit.

[Operation and Effect] According to the substrate conveyance apparatus of the present invention, the pair of imaging units captures an image of a region including the substrate holding unit and a space in front of the substrate holding unit. The image captured by the pair of imaging units is an image of a region including the substrate holding unit and a space in front of the substrate holding unit. The positional information of the conveyance target is calculated based on the images of the substrate holding unit and the conveyance target object captured by the pair of imaging units. Thus, an operation that is difficult to automate, such as installing a teaching member such as a simulated substrate or a teaching jig on a conveyance destination or the like can be omitted when teaching of the positional information of the conveyance target object is performed. Therefore, the configuration of the substrate conveyance apparatus can be simplified, and the teaching work can be automated.

The pair of imaging units captures a reference image and an advanced image. The reference image is an image in which the substrate holding unit at the reference position appears. The advanced image is an image in which the substrate holding unit at the advanced position appears. The substrate holding unit is moved from the reference position to the advanced position by the drive control unit issuing an instruction to advance the substrate holding unit from the reference position by an advancing amount in a first direction. The reference position calculation unit calculates reference positional information by using the reference image. The advanced position calculation unit can calculate advanced positional information by using the advanced image. The estimated moving amount calculation unit calculates the estimated moving amount using the reference positional information and the advanced positional information. The estimated moving amount corresponds to a distance by which the substrate holding unit is estimated to have moved from the reference position to the advanced position.

The pair of imaging units is disposed at a predetermined interval. That is, the pair of imaging units functions as a stereo camera. Thus, the position of the substrate holding unit can be calculated for each of the three-dimensional directions by using the reference image or the advanced image. Further, the imaging unit is disposed in the substrate conveyance apparatus so as not to move with the movement of the substrate holding unit. That is, even when the substrate holding unit advances in the first direction, the imaging unit does not shift its position. Thus, the position of the substrate holding unit appearing in the reference image is different from the position of the substrate holding unit appearing in the advanced image. Therefore, the estimated moving amount of the substrate holding unit on the image can be calculated according to the distance between the position of the substrate holding unit appearing in the reference image and the position of the substrate holding unit appearing in the advanced image.

The substrate conveyance apparatus according to the present invention includes a correction coefficient calculation unit and a calibration unit. The correction coefficient calculation unit calculates a correction coefficient by using the estimated moving amount and the advancing amount. The correction coefficient corrects a difference between the estimated moving amount and the advancing amount. That is, even when there is a difference between the value of the moving distance instructed by the drive control unit and the value of the moving distance assumed from the image captured by the imaging unit, the difference can be corrected with the correction coefficient.

The calibration unit acquires the corrected positional information by calibrating the target object positional information using the correction coefficient. The target object positional information is information on the position of the conveyance target object with respect to the imaging unit, which is calculated using the target object image obtained by capturing an image of the conveyance target object with the imaging unit. The target object positional information is information calculated from the image. Even when there is a difference between the value of the moving distance instructed by the drive control unit and the value of the moving distance assumed from the image captured by the imaging unit, the difference included in the target object positional information is calibrated by the calibration unit.

The corrected positional information acquired by the calibration unit is accurate information as information for controlling the movement of the substrate conveyance apparatus to the substrate target object. Thus, by storing not the target object positional information but the corrected positional information as the positional information of the conveyance target object, it is possible to teach more accurate information as the position of the conveyance target object to the substrate conveyance apparatus. Thus, in the configuration in which the positional information of the conveyance target object is calculated using the image captured by the imaging unit, it is possible to avoid a degradation in the accuracy of the positional information due to a positional deviation of the imaging unit, a coordinate deviation of the image, or the like. Therefore, it is possible to further improve the accuracy of the information to be taught through the teaching work while automating the teaching work using the image captured by the imaging unit.

In the above-described invention, it is preferable that the first direction is a horizontal direction, the second direction is an up/down direction, and the movable table is movable at least in the up/down direction and rotatable around an axis in the up/down direction.

[Operation and Effect] According to the substrate conveyance apparatus of the present invention, the substrate holding unit moves in the horizontal direction. The movable table is configured to be movable in the up/down direction and to be rotatable around an axis in the up/down direction. That is, the substrate holding unit held by the movable table is movable in the horizontal direction and the up/down direction, and is configured to be rotatable around the axis in the up/down direction. That is, it is possible to teach the target position of the substrate holding unit to the substrate conveyance apparatus in which the substrate holding unit shifts in the three-dimensional directions.

In the above-described invention, it is preferable that the substrate conveyance apparatus includes a notification unit that notifies, when a difference between the estimated moving amount and the advancing amount has a value equal to or more than a predetermined value, information indicating that the difference between the estimated moving amount and the advancing amount has a value equal to or more than a predetermined value.

[Operation and Effect] The substrate conveyance apparatus according to the present invention includes a notification unit. The notification unit notifies information indicating that a difference between the estimated moving amount and the advancing amount has a value equal to or more than a predetermined value. When the difference between the estimated moving amount and the advancing amount has a value equal to or more than a predetermined value, a situation is assumed in which deterioration over time is large in the configuration of the substrate holding unit, the imaging unit, or the like. By performing the notification, the operator can quickly grasp that the difference between the estimated moving amount and the advancing amount has a value equal to or larger than a predetermined value. Thus, it is possible to quickly and reliably avoid a situation in which the accuracy of the information on the position of the conveyance target object degrades because of deterioration over time of the substrate holding unit, the imaging unit, or the like.

To achieve such an object, the present invention may have the following configuration.

That is, the present invention is a position teaching method for teaching a position of a conveyance target object to a substrate conveyance apparatus that conveys a substrate to the conveyance target object, the substrate conveyance apparatus including:

> a substrate holding unit movable in a first direction while holding a substrate;
> a movable table that holds the substrate holding unit and is movable at least in a second direction different from the first direction;
> a pair of imaging units disposed on the movable table at a predetermined interval in such a manner as to move with movement of the movable table but not with movement of the substrate holding unit, the pair of imaging units being configured to capture an image of a region including the substrate holding unit and a space in front of the substrate holding unit;
> an advance/retraction drive unit that drives the substrate holding unit to advance or retract in the first direction; and
> a drive control unit that transmits information on a drive distance in the first direction to the advance/retraction drive unit to control an operation of the advance/retraction drive unit,
> the method comprising:

> > a reference image acquisition step of acquiring a reference image by capturing an image of the substrate holding unit disposed at a reference position in the substrate conveyance apparatus with the pair of imaging units;
> > a reference distance calculation step of calculating a position of the substrate holding unit with respect to the pair of imaging units as reference positional information based on the reference image;
> > an advanced image acquisition step of acquiring an advanced image by capturing, with the pair of imaging units, an image of the substrate holding unit advanced from the reference position in the first direction by a predetermined advancing amount by the drive control unit;
> > an advanced distance calculation step of calculating the position of the substrate holding unit with respect to the pair of imaging units as advanced positional information based on the advanced image;
> > an estimated moving amount calculation step of calculating an estimated moving amount that is a distance by which the substrate holding unit is estimated to have moved from the reference position to the advanced position based on the reference positional information and the advanced positional information;
> > a correction coefficient calculation step of calculating a correction coefficient for correcting a difference between the estimated moving amount and the advancing amount by using the estimated moving amount and the advancing amount;
> > a target object image acquisition step of acquiring a target object image by capturing an image of the conveyance target object with the pair of imaging units;
a target object position calculation step of calculating a position of the conveyance target object with respect to the pair of imaging units as target object positional information based on the target object image captured by the pair of imaging unit;
a calibration step of acquiring corrected positional information by calibrating the target object positional information using the correction coefficient; and
a teaching step of teaching the corrected positional information acquired in the calibration step as the position of the conveyance target object.

[Operation and Effect] According to the position teaching method of the present invention, the pair of imaging units captures an image of a region including the substrate holding unit and a space in front of the substrate holding unit. The image captured by the pair of imaging units is an image of a region including the substrate holding unit and a space in front of the substrate holding unit. The positional information of the conveyance target is calculated based on the images of the substrate holding unit and the conveyance target object captured by the pair of imaging units. Thus, an operation that is difficult to automate, such as installing a teaching member such as a simulated substrate or a teaching jig on a conveyance destination or the like can be omitted when teaching of the positional information of the conveyance target object is performed. Therefore, the configuration of the substrate conveyance apparatus can be simplified, and the teaching work can be automated.

The pair of imaging units captures a reference image and an advanced image. The reference image is an image in which the substrate holding unit at the reference position appears. The advanced image is an image in which the substrate holding unit at the advanced position appears. The substrate holding unit is moved from the reference position to the advanced position by the drive control unit issuing an instruction to advance the substrate holding unit from the reference position by an advancing amount in a first direction. In the reference position calculation step, the reference positional information is calculated by using the reference image. In the advanced distance calculation step, the advanced positional information is calculated by using the advanced image. In the estimated moving amount calculation step, the estimated moving amount is calculated by using the reference positional information and the advanced positional information. The estimated moving amount corresponds to a distance by which the substrate holding unit is estimated to have moved from the reference position to the advanced position.

The pair of imaging units is disposed at a predetermined interval. That is, the pair of imaging units functions as a stereo camera. Thus, the position of the substrate holding unit can be calculated for each of the three-dimensional directions by using the reference image or the advanced image. Further, the imaging unit is disposed in the substrate conveyance apparatus so as not to move with the movement of the substrate holding unit. That is, even when the substrate holding unit advances in the first direction, the imaging unit does not shift its position. Thus, the position of the substrate holding unit appearing in the reference image is different from the position of the substrate holding unit appearing in the advanced image. Therefore, the estimated moving amount of the substrate holding unit on the image can be calculated according to the distance between the position of the substrate holding unit appearing in the reference image and the position of the substrate holding unit appearing in the advanced image.

The position teaching method according to the present invention includes a correction coefficient calculation step and a calibration step. The correction coefficient calculation unit calculates a correction coefficient by using the estimated moving amount and the advancing amount. The correction coefficient corrects a difference between the estimated moving amount and the advancing amount. That is, even when there is a difference between the value of the moving distance instructed by the drive control unit and the value of the moving distance assumed from the image captured by the imaging unit, the difference can be corrected with the correction coefficient.

In the calibration step, the corrected positional information is acquired by calibrating the target object positional information using the correction coefficient. The target object positional information is information on the position of the conveyance target object with respect to the imaging unit, which is calculated using the target object image obtained by capturing an image of the conveyance target object with the imaging unit. The target object positional information is information calculated from the image. Even when there is a difference between the value of the moving distance instructed by the drive control unit and the value of the moving distance assumed from the image captured by the imaging unit, the difference included in the target object positional information is calibrated by the calibration unit.

The corrected positional information acquired through the calibration step is accurate information as information for controlling the movement of the substrate conveyance apparatus to the substrate target object. Thus, in the teaching step, by teaching not the target object positional information but the corrected positional information as the positional information of the conveyance target object, it is possible to teach more accurate information as the position of the conveyance target object to the substrate conveyance apparatus. Thus, in the configuration in which the positional information of the conveyance target object is calculated using the image captured by the imaging unit, it is possible to avoid a degradation in the accuracy of the positional information due to a positional deviation of the imaging unit, a coordinate deviation of the image, or the like. Therefore, it is possible to further improve the accuracy of the information to be taught through the teaching work while automating the teaching work using the image captured by the imaging unit.

In the above-described invention, it is preferable that the method includes a notification step of notifying, when a difference between the estimated moving amount calculated in the estimated moving amount calculation step and the advancing amount has a value equal to or more than a predetermined value, information that the difference between the estimated moving amount and the advancing amount has a value equal to or more than a predetermined value.

[Operation and Effect] According to the position teaching method according to the present invention, in the notification step, information indicating that the difference between the estimated moving amount and the advancing amount has a value equal to more than a predetermined value is notified. When the difference between the estimated moving amount and the advancing amount has a value equal to or more than a predetermined value, the accuracy of the target position of the substrate holding unit taught by the substrate conveyance apparatus is often degraded. Through the notification in the notification step, the operator can quickly grasp that the difference between the estimated moving amount and the advancing amount has a value equal to or more than a predetermined value. Thus, it is possible to quickly and reliably avoid a situation in which the accuracy of the target position of the substrate holding unit degrades.

According to the substrate conveyance apparatus and the position teaching method of the present invention, it is possible to automate the teaching work with a simpler configuration.

BRIEF DESCRIPTION OF DRAWINGS

FIG. 1 is a plan view of a substrate processing apparatus according to Example;
FIG. 2 is a longitudinal sectional view of the substrate processing apparatus according to Example;
FIG. 3 is a longitudinal sectional view of the substrate processing apparatus, illustrating the disposition of thermal processing units according to Example;
FIGS. 4A to 4C are a diagram illustrating a configuration of a substrate placement unit according to Example;

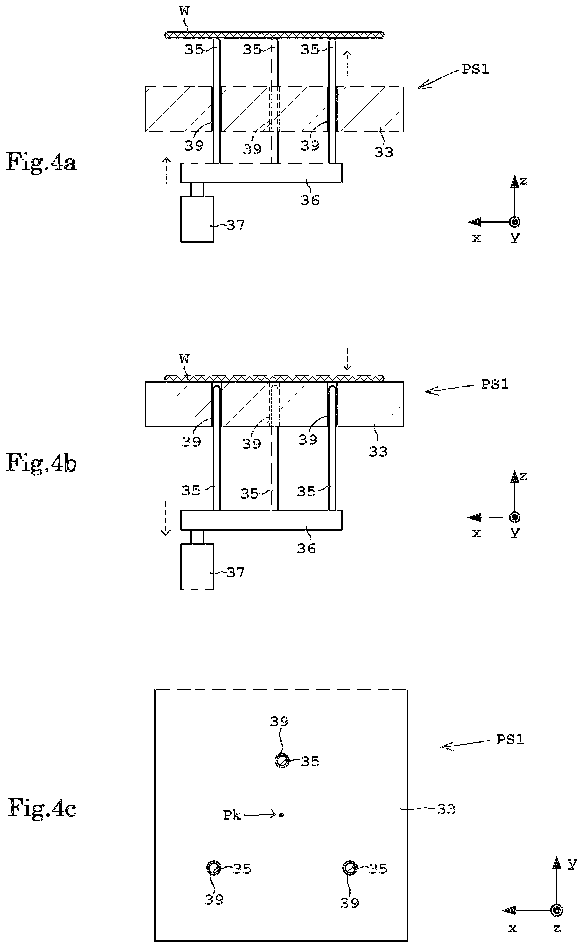

FIG 4A. is a longitudinal sectional view of the substrate placement unit illustrating a state in which a support pin is at a projection position, FIG 4B is a longitudinal sectional view of the substrate placement unit illustrating a state in which the support pin is at a retracting position, and FIG.4C is a plan view of the substrate placement unit;

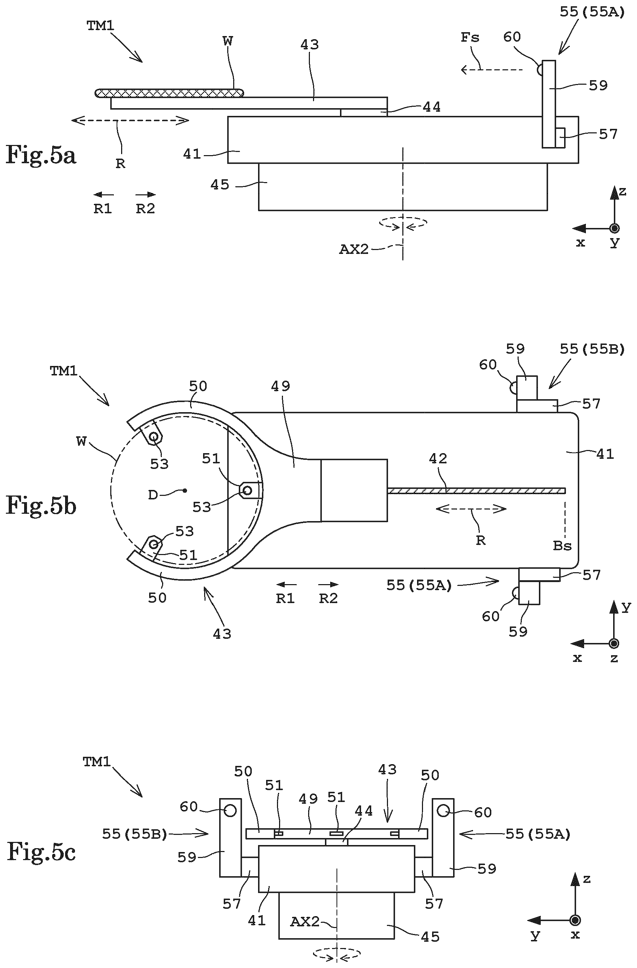

FIGS. 5A to 5C are diagrams illustrating a configuration of a substrate conveyance mechanism according to Example;
FIG. 5A is a front view of the substrate conveyance mechanism, FIG. 5B is a plan view of the substrate conveyance mechanism, and FIG. 5C is a left side view of the substrate conveyance mechanism;

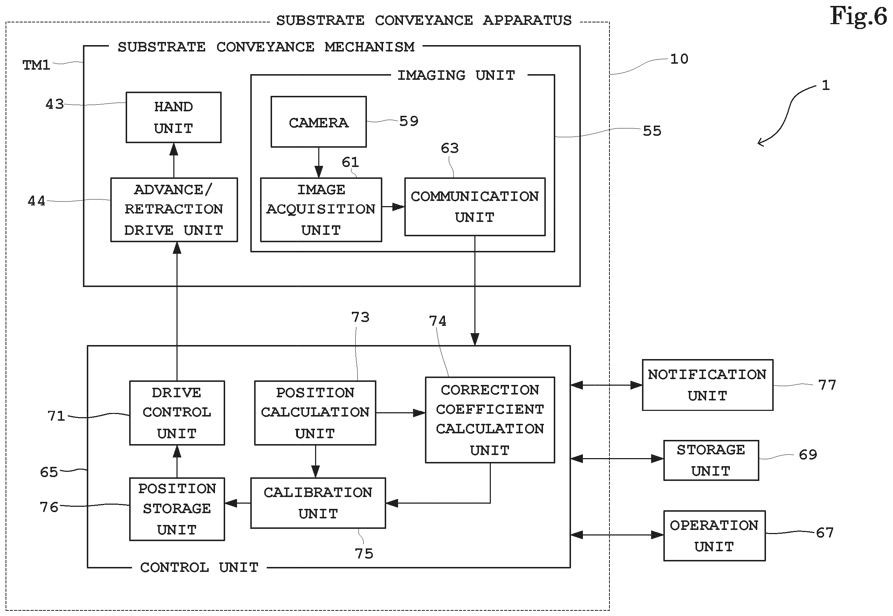

FIG. 6 is a functional block diagram of the substrate processing apparatus according to Example;

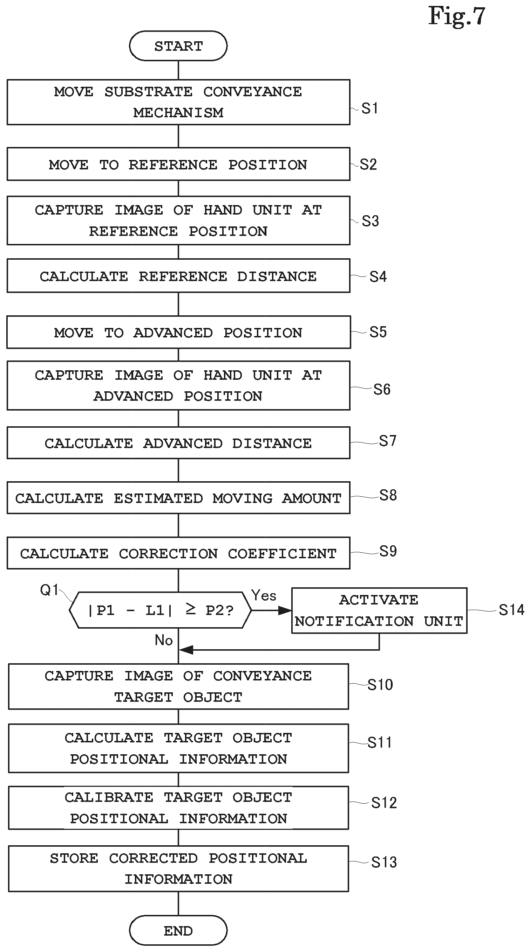

FIG. 7 is a flowchart illustrating an operation of the substrate conveyance apparatus according to Example;

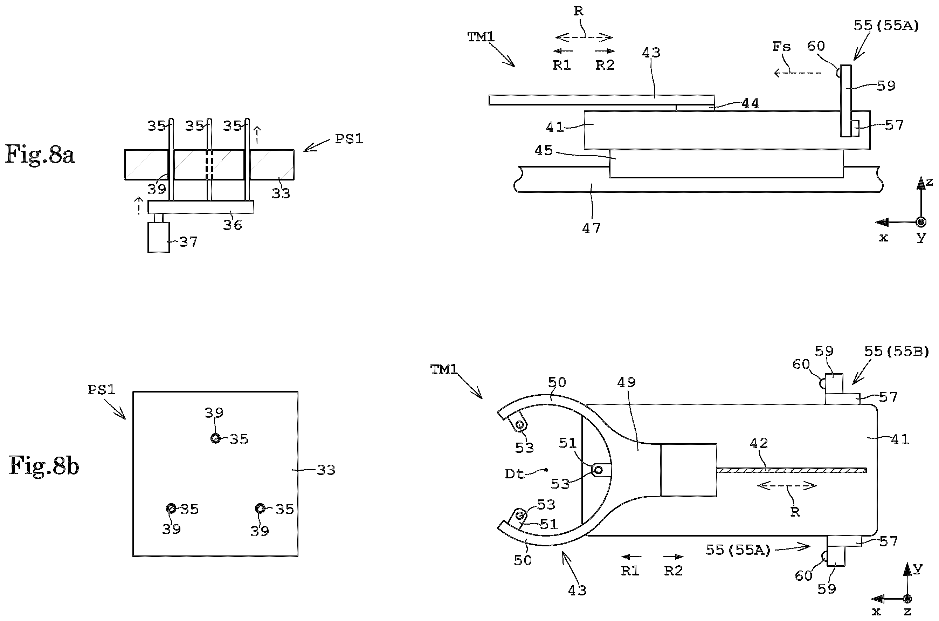

FIGS. 8A and 8B are diagrams for describing step S1 according to Example;
FIG, 8A is a front view of the substrate conveyance mechanism and the substrate placement unit, and FIG. 8B is a plan view of the substrate conveyance mechanism and the substrate placement unit;

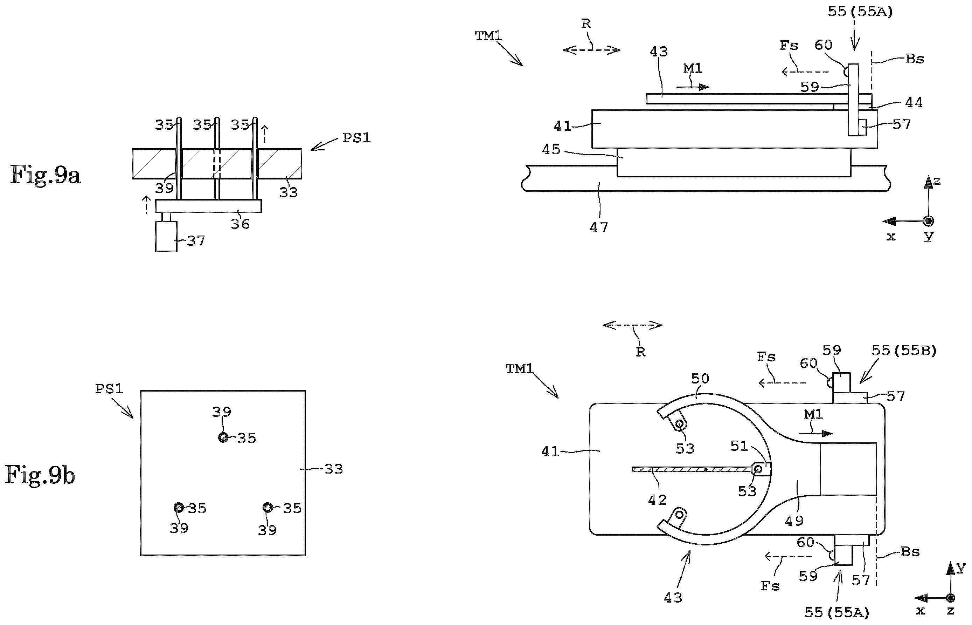

FIGS. 9A and 9B are diagrams for describing step S2 according to Example;
FIG, 9A is a front view of the substrate conveyance mechanism and the substrate placement unit, and FIG. 9B is a plan view of the substrate conveyance mechanism and the substrate placement unit;

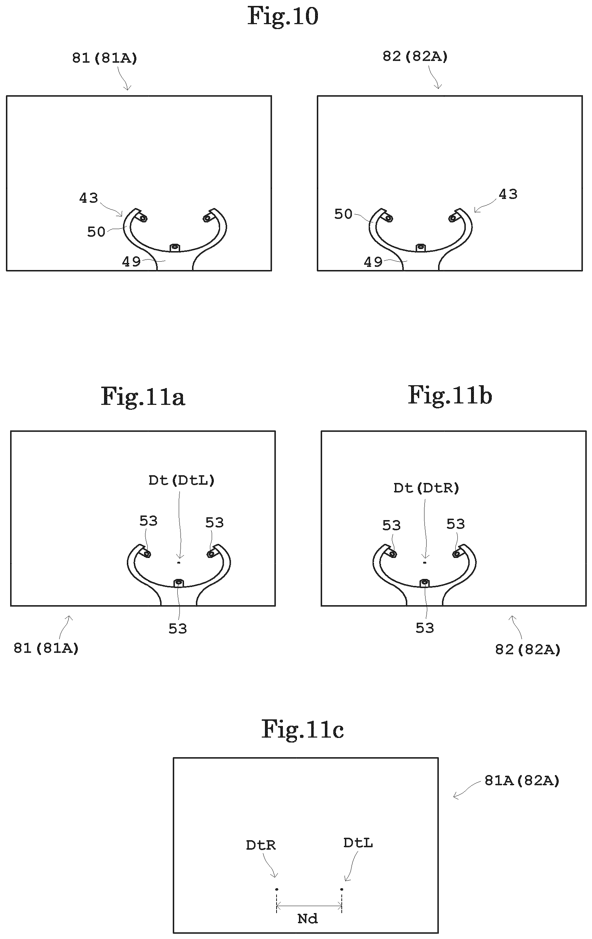

FIG. 10 is a diagram for describing an optical image acquired in step S3 according to Example;
FIGS. 11A to 11C are diagrams for describing step S4 according to Example;
FIG. 11A is a diagram illustrating a first optical image, FIG 11B is a diagram illustrating a second optical image, and FIG 11C is a diagram illustrating parallax between the two optical images;

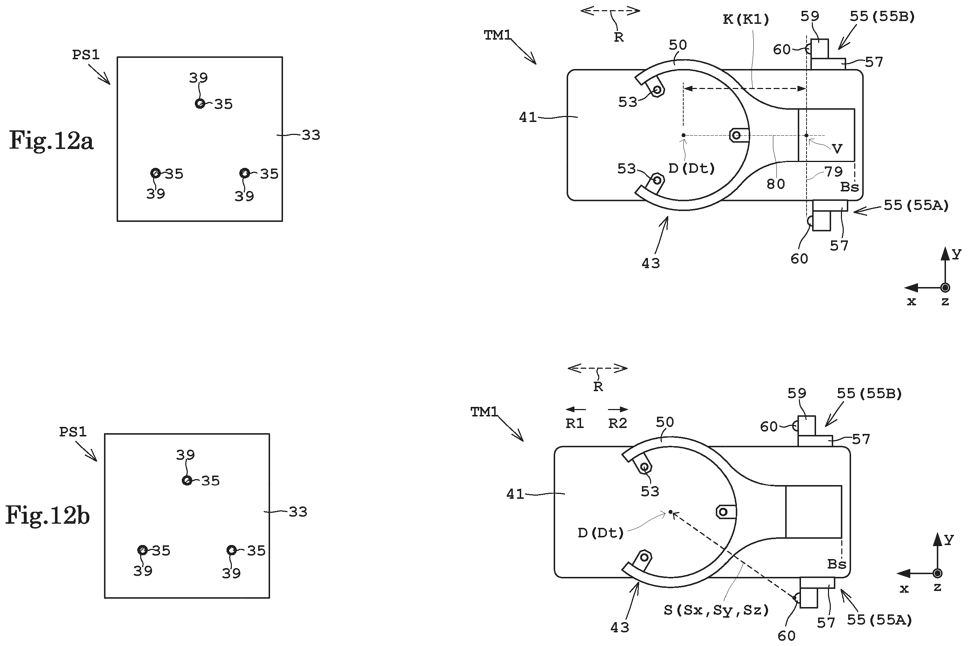

FIGS. 12A and 12B are diagrams for describing step S4 according to Example;
FIG 12A is a diagram illustrating a reference distance of a hand unit, and FIG 12B is a diagram illustrating a three-dimensional distance of the center of the hand unit;

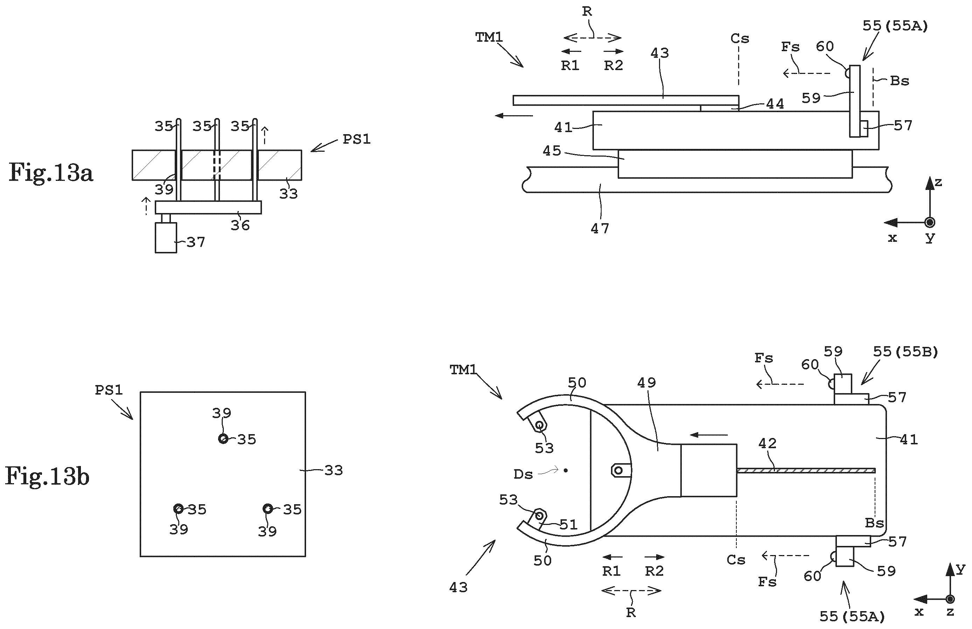

FIGS. 13A and 13B are diagrams for describing step S5 according to Example;
FIG, 13A is a front view of the substrate conveyance mechanism and the substrate placement unit, and FIG. 13B is a plan view of the substrate conveyance mechanism and the substrate placement unit;

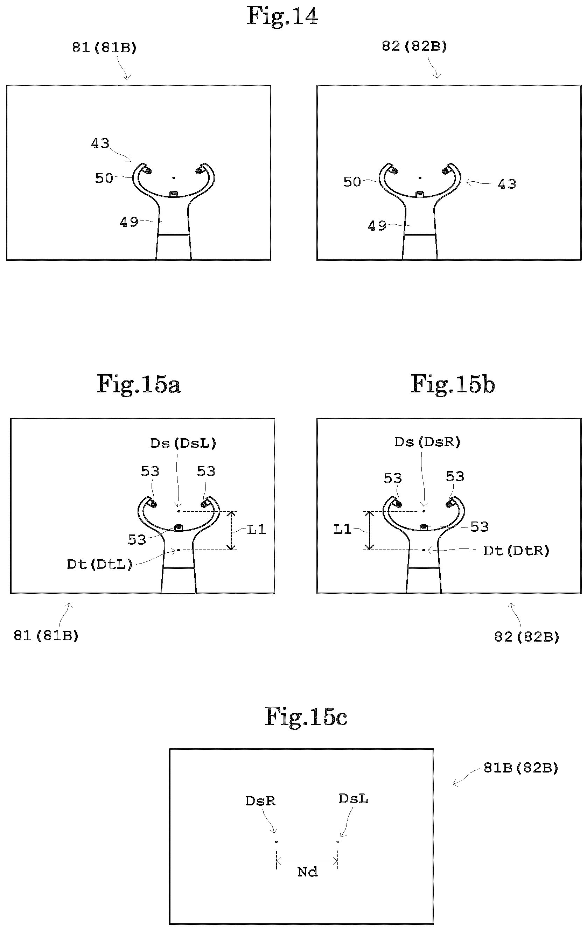

FIG. 14 is a diagram for describing an optical image acquired in step S6 according to Example;
FIGS. 15A to 15C are diagrams for describing step S7 according to Example;
FIG. 15A is a diagram illustrating a first optical image, FIG 15B is a diagram illustrating a second optical image, and FIG 15C is a diagram illustrating parallax between the two optical images;

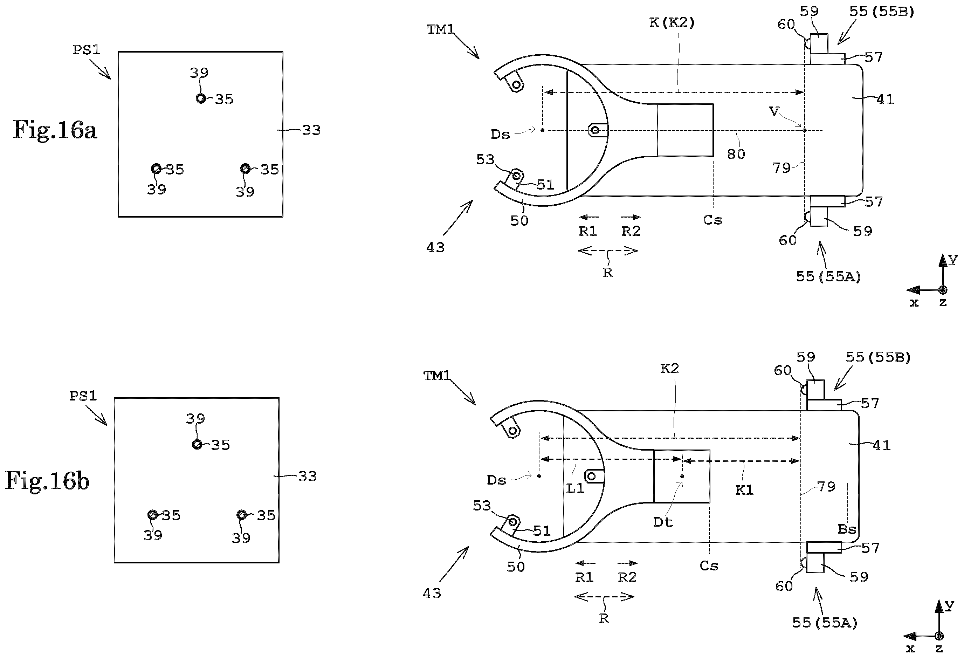

FIGS. 16A and 16B are diagrams for describing step S7 according to Example;
FIG. 16A is a diagram illustrating an advanced distance of the hand unit, and FIG 16B is a diagram illustrating an estimated moving amount of the hand unit;

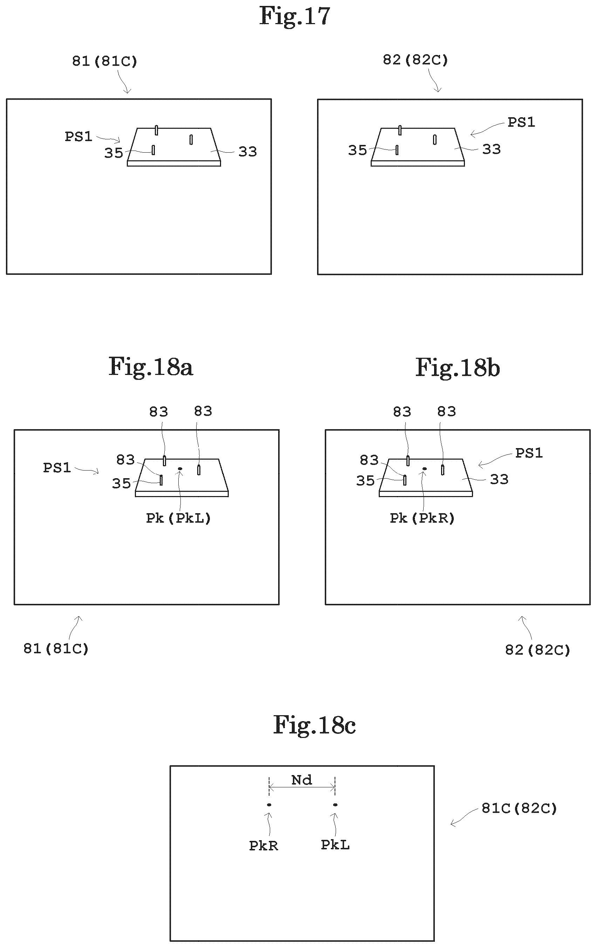

FIG. 17 is a diagram for describing an optical image acquired in step S10 according to Example;
FIGS. 18A to 18C are diagrams for describing step S11 according to Example;

FIG. 18A is a diagram illustrating a first optical image, FIG 18B is a diagram illustrating a second optical image, and FIG 18C is a diagram illustrating parallax between the two optical images;

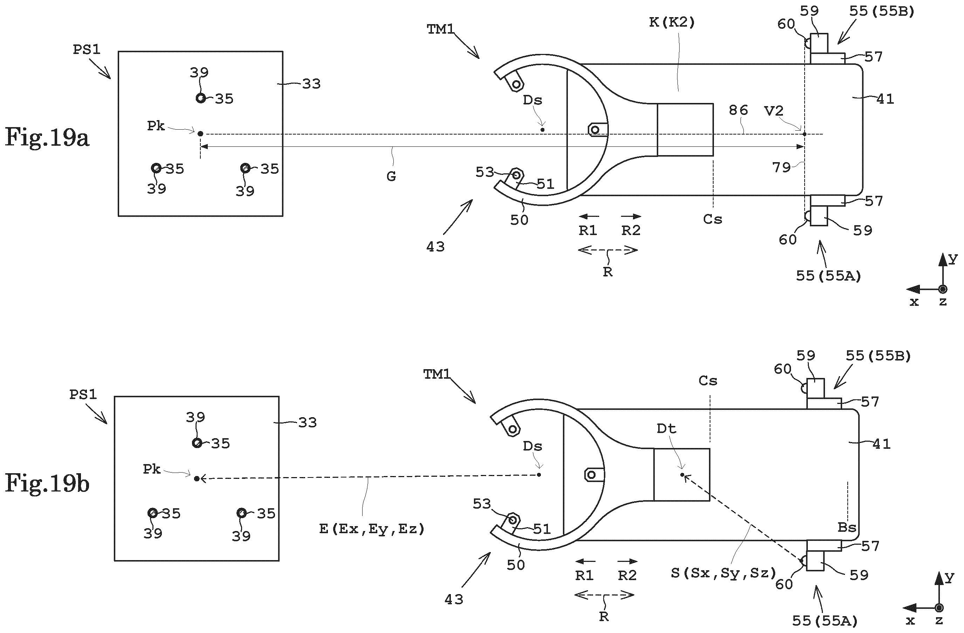

FIGS. 19A and 19B are diagrams for describing step S11 according to Example;

FIG. 19A is a diagram illustrating a target object distance of the substrate placement unit, and FIG 19B is a diagram illustrating a necessary moving amount of the hand unit;

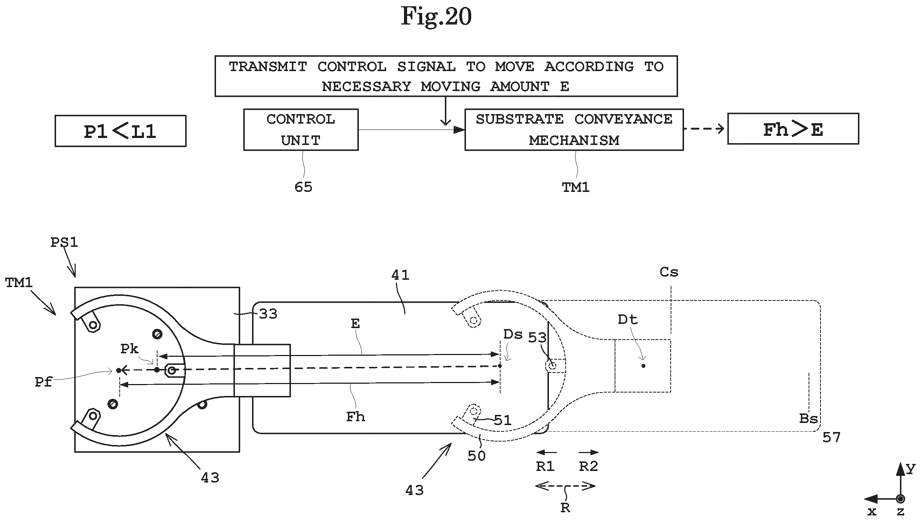

FIG. 20 is a plan view for describing movement of a hand unit according to Comparative Example;

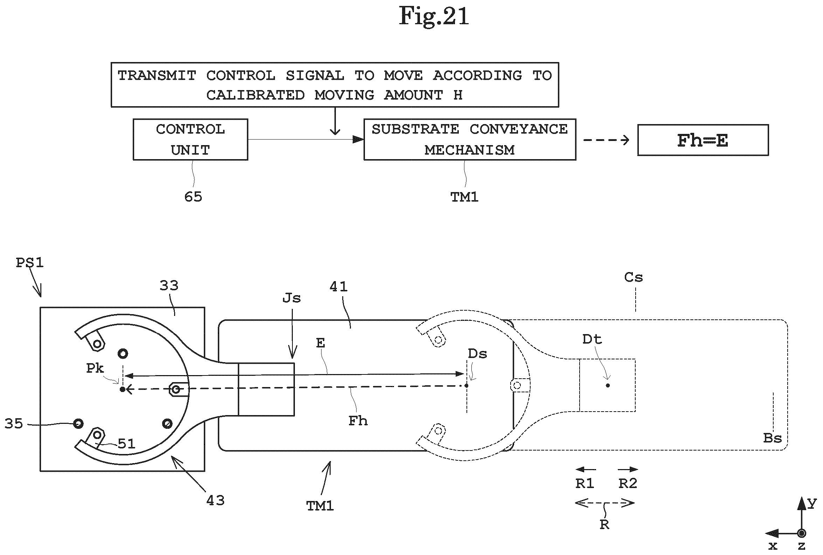

FIG. 21 is a plan view for describing movement of the hand unit according to Example; and

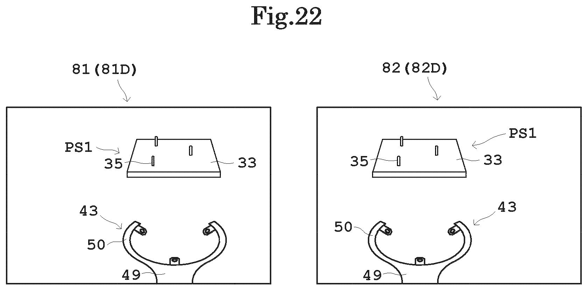

FIG. 22 is a diagram illustrating an optical image according to a modification.

DETAILED DESCRIPTION

Hereinafter, Example of the present invention will be described with reference to the drawings.

<Configuration of Substrate Processing Apparatus>

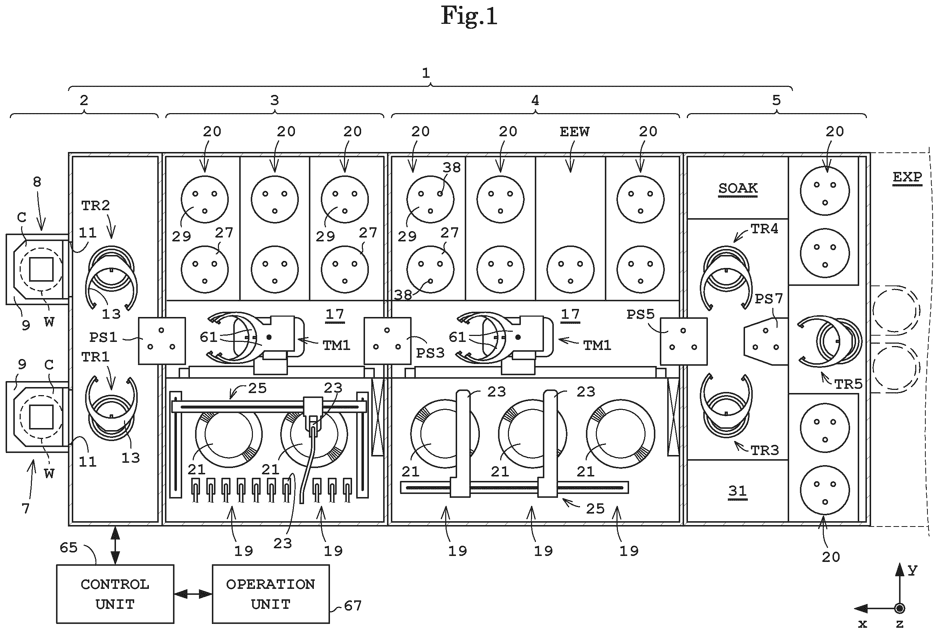

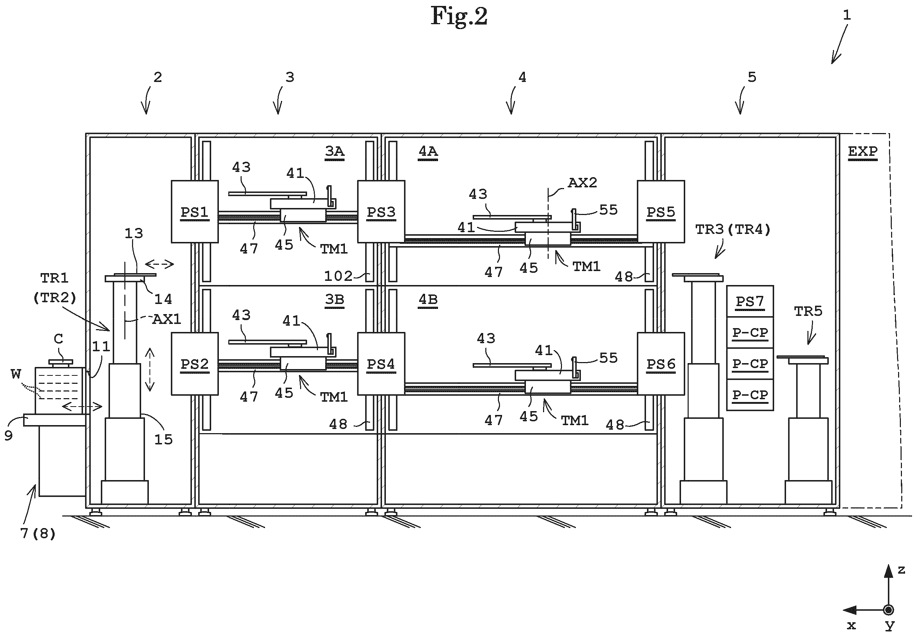

FIG. 1 is a transverse sectional view illustrating a substrate processing apparatus 1 including a substrate conveyance apparatus 10 according to Example. FIG. 2 is a longitudinal sectional view of the substrate processing apparatus 1. The substrate processing apparatus 1 forms a photoresist film on a substrate W and performs development on the substrate W after exposure.

As illustrated in FIG. 1, the substrate processing apparatus 1 according to Example includes an indexer block 2, a coating block 3, a development block 4, and an interface block 5. Hereinafter, the indexer block 2 is appropriately referred to as "ID block 2". Hereinafter, the interface block 5 is appropriately referred to as "IF block 5". An exposure device EXP, which is an external device, is disposed adjacent to the IF block 5. In the substrate processing apparatus 1, a direction in which the blocks are arranged (the right-and-left direction in FIG. 1) is defined as an x direction. The x direction is a horizontal direction. The horizontal direction orthogonal to the x direction is defined as a y direction. A vertical direction is defined as a z direction.

The ID block 2 includes two openers 7 and 8 (see FIG. 1) and two substrate conveyance mechanisms TR1 and TR2. Each of the two openers 7 and 8 (carrier placement units) provided in the ID block 2 places a carrier C capable of storing a plurality of substrates W. As the carrier C, for example, a front open unified pod (FOUP) is used.

Each of the openers 7 and 8 includes a stage 9 on which the carrier C is placed, an opening 11 to allow the substrate W to pass therethrough, a shutter member (not illustrated) that opens and closes the opening 11 and attaches and detaches a lid to and from a carrier body, and a shutter member drive mechanism (not illustrated) that drives the shutter member.

Each of the two substrate conveyance mechanisms TR1 and TR2 includes a hand 13, a rotary drive unit 14, and a lifting drive unit 15. The hand 13 holds the substrate W. The hand 13 is attached to an upper surface portion of the rotary drive unit 14. A groove (not illustrated) is formed on the upper surface of the rotary drive unit 14 extending in a predetermined horizontal direction. The hand 13 is configured so as to be able to advance and retract in predetermined horizontal directions along the groove. The hand 13 is configured in the same manner as a hand 43 of the substrate conveyance mechanism TM1 described later.

The rotary drive unit 14 is attached to an upper end of the lifting drive unit 15. As illustrated in FIG. 2, the rotary drive unit 14 is configured to be rotatable around a vertical axis AX1. That is, when the rotary drive unit 14 rotates, the hand 13 rotates around the vertical axis AX1.

The lifting drive unit 15 is configured to be movable up and down. When the lifting drive unit 15 moves up and down, the rotary drive unit 14 moves in the up/down (z direction) together with the hand 13. That is, the hand 13 can be moved up and down and rotated by the rotary drive unit 14 and the lifting drive unit 15. Each of the hand 13, the rotary drive unit 14, and the lifting drive unit 15 includes, for example, an electric motor. In Example, the lifting drive unit 15 is fixed to the floor of the ID block 2 so as not to be movable in the horizontal direction. However, the lifting drive unit 15 may be provided to be movable in the horizontal direction. One of the two substrate conveyance mechanisms TR1 and TR2 may be omitted.

As illustrated in FIG. 2, a substrate placement unit PS1 and a substrate placement unit PS2 are provided between the ID block 2 and the coating block 3. The substrate placement unit PS1 is provided between the ID block 2 and a coating processing layer 3A on the upper side described later. The substrate placement unit PS2 is provided between the ID block 2 and a coating processing layer 3B on the lower side described later. Each of the substrate placement units PS1 and PS2 is configured such that one or a plurality of substrates W can be placed thereon.

The substrate conveyance mechanism TR1 conveys the substrate W from the carrier C placed on the opener 7 to one of the two substrate placement units PS1 and PS2. The substrate conveyance mechanism TR2 conveys the substrate W from the carrier C placed on the opener 8 to one of the two substrate placement units PS1 and PS2. Two or more openers 7 and 8 may be provided in the up/down direction. In this case, for example, the substrate conveyance mechanism TR1 can take out the substrate W from the carrier C placed on two or more openers 7 provided in the up/down direction.

The coating block 3 performs coating processing of applying, for example, a photoresist liquid or a liquid for forming an antireflection film to the substrate W. As illustrated in FIG. 2, the coating block 3 includes the coating processing layer 3A on the upper side and the coating processing layer 3B on the lower side. The development block 4 performs development processing on the substrate W that has been exposed. The development block 4 includes a development processing layer 4A on the upper side and a development processing layer 4B on the lower side. Each of the coating processing layer 3A, the coating processing layer 3B, the development processing layer 4A, and the development processing layer 4B includes a substrate conveyance mechanism TM1, a conveyance space 17, a liquid processing unit 19, and a thermal processing unit 20 (see FIGS. 4A to 4C and 5A to 5C).

The substrate conveyance mechanism TM1 conveys the substrate W in the conveyance space 17. The conveyance space 17 is a rectangular space linearly extending in the right-and-left direction (x direction) in plan view. The liquid processing unit 19 and the thermal processing unit 20 are disposed so as to sandwich the conveyance space 17 from front and back.

A substrate placement unit PS3 is provided between the coating processing layer 3A on the upper side and the development processing layer 4A on the upper side. A substrate placement unit PS4 is provided between the lower coating processing layer 3B and the lower development processing layer 4B. A substrate placement unit PS5 is provided between the development processing layer 4A on the upper side and the IF block 5. A substrate placement unit PS6 is provided between the development processing layer 4B on the lower side and the IF block 5.

Each of the coating processing layers 3A and 3B includes four liquid processing units 19. The four liquid processing units 19 are disposed in 2 columns × 2 rows of 2 columns in the horizontal direction and 2 rows in the up/down direction. Each of the development processing layers 4A and 4B includes six liquid processing units 19. The six liquid processing units 19 are disposed in 3 columns × 2 rows of 3 columns in the horizontal direction and 2 rows in the up/down direction.

As illustrated in FIG. 2, the liquid processing unit 19 includes a hold rotation unit 21, a nozzle 23, and a nozzle moving mechanism 25. The hold rotation unit 21 holds the substrate W through vacuum suction, for example, and rotates the held substrate W around the vertical axis (z direction). The rotation is performed by an electric motor (for example, a stepping motor). The nozzle 23 supplies a coating liquid (for example, a liquid for forming an antireflection film or a photoresist liquid) or a developing solution to the substrate W. The nozzle moving mechanism 25 moves the nozzle 23 to any positions. The nozzle moving mechanism 25 includes, for example, an electric motor.

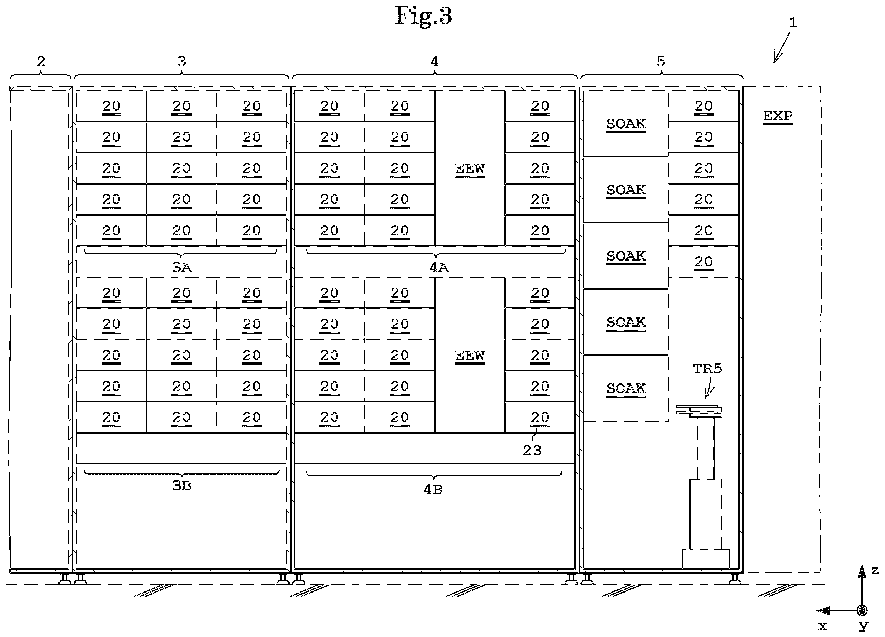

FIG. 3 is a diagram illustrating the disposition of the thermal processing units 20 in the coating block 3 and the development block 4. The thermal processing unit 20 performs thermal processing (heat processing and cooling processing) on the substrate W. Each of the four processing layers 3A, 3B, 4A, and 4B includes a plurality of thermal processing units 20.

In the two coating processing layers 3A and 3B, the thermal processing units 20 can be disposed in 3 columns × 5 rows. In FIG. 3, each of the two coating processing layers 3A and 3B includes 15 thermal processing units 20. On the other hand, in the two development processing layers 4A and 4B, the thermal processing units 20 can be disposed in 4 columns × 5 rows. An edge exposure unit EEW may be provided in the space where the thermal processing unit 20 is provided. In Example, each of the two development processing layers 4A and 4B includes 15 thermal processing units 20 and one edge exposure unit EEW.

The edge exposure unit EEW performs exposure processing of a peripheral part on the substrate W. The edge exposure unit EEW includes a hold rotation unit similar to the hold rotation unit 21 illustrated in FIG. 1. The hold rotation unit of the edge exposure unit EEW includes an electric motor (for example, a stepping motor). The numbers and types of the liquid processing units 19 and the thermal processing units 20 are appropriately changed.

As illustrated in FIG. 1, each of the thermal processing units 20 includes a cooling plate 27 and a heating plate 29. The cooling plate 27 cools the substrate W that has been placed. The cooling plate 27 has a disk shape and is made of, for example, metal or ceramic. The heating plate 29 heats the placed substrate W by increasing the temperature of the substrate W to a predetermined temperature. The heating plate 29 is disposed side by side in the horizontal direction (y direction) with respect to the cooling plate 27. The heating plate 29 has a disk shape and is made of metal or ceramic. The heating plate 29 includes a heater (for example, an electric heater).

The IF block 5 loads and unloads the substrate W into and from the exposure device EXP that performs exposure processing. The IF block 5 includes three substrate conveyance mechanisms TR3 to TR5, a plurality of pre-exposure cleaning units 31, a plurality of post-exposure cleaning units SOAK, three placement/cooling units P-CP, a substrate placement unit PS7, and the thermal processing unit 20 (see FIGS. 1 to 3).

The substrate conveyance mechanism TR3 and the substrate conveyance mechanism TR4 are arranged side by side in the y direction. The substrate conveyance mechanism TR5 is disposed on the right side of the substrate conveyance mechanisms TR3 and TR4. The three substrate conveyance mechanisms TR3 to TR5 are configured in the same manner as the substrate conveyance mechanism TR1.

The pre-exposure cleaning unit 31 and the post-exposure cleaning unit SOAK are provided so as to face each other with the two substrate conveyance mechanisms TR3 and TR4 interposed therebetween. Each of the pre-exposure cleaning unit 31 and the post-exposure cleaning unit SOAK includes a hold rotation unit that holds the substrate W, and a nozzle that discharges a cleaning liquid to the substrate W, for example. The hold rotation unit is configured in the same manner as the hold rotation unit 21. The pre-exposure cleaning unit 31 may also perform polishing processing on the back surface and the end (bevel) of the substrate W using a brush or the like. The back surface of the substrate W refers to, for example, the surface opposite to the surface on which a circuit pattern is formed.

Three placement/cooling units P-CP and a substrate placement unit PS7 are provided between the three substrate conveyance mechanisms TR3 to TR5. In the IF block 5, six thermal processing units 20 are provided on each of the substrate conveyance mechanism TR3 side and the substrate conveyance mechanism TR4 side.

<Configuration of Substrate Placement Unit>

Here, the configuration of the substrate placement unit PS1 for placing the substrate W that has been conveyed will be described. FIGS. 4A and 4B are longitudinal sectional views of the substrate placement unit PS1. FIG. 4C is a plan view of the substrate placement unit PS1.

The substrate placement unit PS1 includes a holding plate 33, support pins 35, a lifting member 36, and a support pin lifting mechanism 37. The holding plate 33 is a rectangular plate-like member and has a flat upper surface. The holding plate 33 places and holds the substrate W thereon. The holding plate 33 is made of metal or ceramic, as an example.

The holding plate 33 is provided with three holes 39 in the vertical direction (z direction). The rod-shaped support pin 35 passes through each of the holes 39. That is, three support pins 35 are provided so as to penetrate the holding plate 33. Lower ends of the three support pins 35 are fixed to the lifting member 36. The support pin lifting mechanism 37 lifts and lowers the three support pins 35 fixed to the lifting member 36 by lifting and lowering the lifting member 36. As an example, the support pin lifting mechanism 37 includes an electric motor or an actuator driven by the air.

The upper ends of the three support pins 35 are configured to have the same height. The three support pins 35 are configured to be movable up and down by the support pin lifting mechanism 37. That is, as illustrated in FIG. 4A, each of the support pins 35 projects from the substrate holding surface (upper surface) of the holding plate 33 by being lifted by the support pin lifting mechanism 37. FIG. 4A illustrates a state in which each of the support pins 35 is lifted from the initial position to a projection position. Each of the support pins 35 moves to the projection position and projects from the holding plate 33, and thus the support pins 35 can receive the substrate W.

Then, as illustrated in FIG. 4B, each of the support pins 35 is incorporated in the holding plate 33 by being lowered by the support pin lifting mechanism 37. FIG. 4B illustrates a state in which each of the support pins 35 is lowered from the projection position to the initial position. In a state where the support pins 35 has received the substrate W, each of the support pins 35 is lowered to the initial position and incorporated in the holding plate 33, whereby the substrate W is placed on the substrate holding surface of the holding plate 33.

The positions of the three holes 39 in plan view are as illustrated in FIG. 4C. In Example, the holes 39 are disposed at positions corresponding to the vertexes of a regular triangle. A pin center Pk corresponding to the center of each vertex of the three support pins 35 is determined to coincide with the center of the holding plate 33 in plan view. In plan view, the pin center Pk coincides with the center of three holes 39.

The substrate placement units PS2 to PS7 have the same configuration as the substrate placement unit PS1. Similarly to the substrate placement unit PS1, the cooling plate 27 and the heating plate 29 also include three support pins 38 that can be moved up and down, a support pin lifting mechanism (not illustrated) that lifts and lowers the three support pins 38, and a hole (not illustrated) through which the three support pins 38 pass.

<Configuration of Substrate Conveyance Mechanism>

Next, a configuration of the substrate conveyance mechanism TM1 that conveys the substrate W will be described.

FIG. 5A is a front view of the substrate conveyance mechanism TM1. FIG. 5B is a plan view of the substrate conveyance mechanism TM1. FIG. 5C is a left side view of the substrate conveyance mechanism TM1.

The substrate conveyance mechanism TM1 includes a base unit 41, a hand unit 43, and a rotary drive unit 45. As illustrated in FIG. 2, the substrate conveyance mechanism TM1 further includes a first moving mechanism 47 and a second moving mechanism 48.

The base unit 41 is, as an example, a rectangular plate-like member whose longer direction is in the x direction. A groove 42 is formed on an upper surface of the base unit 41. As illustrated in FIG. 5B, the groove 42 is formed to extend in the longer direction of the base unit 41. The directions in which the groove 42 extends is defined as R directions. The R directions are horizontal directions in the same manner as the x directions. Of the R directions, the direction toward the tip side of the groove 42 is defined as R1 direction. Of the R directions, the direction toward the base end side of the groove 42 is defined as R2 direction.

The hand unit 43 holds the substrate W. The hand unit 43 is disposed on the upper surface of the base unit 41. An advance/retraction drive unit 44 is disposed below the hand unit 43, and the hand unit 43 is connected to the base unit 41 via the advance/retraction drive unit 44. The advance/retraction drive unit 44 includes, as an example, an electric motor and a movable member guided to the groove. That is, the advance/retraction drive unit 44 is fitted in the groove 42 formed on the upper surface of the base unit 41, and is driven to advance and retract in the R directions along the groove 42. That is, the hand unit 43 is configured to advance and retract in the R directions when the advance/retraction drive unit 44 advances and retracts in the R directions. That is, the advance/retraction drive unit 44 supports the hand unit 43 and causes the hand unit 43 to advance and retract in the R directions. The hand unit 43 corresponds to a substrate holding unit in the present invention.

The hand unit 43 includes one base 49 and two tips 50 separated from the base 49. Three projections 51 are provided inside base 49 and two tips 50. The substrate W is placed on the three projections 51. Each of the three projections 51 has a suction unit 53. The suction unit 53 is connected to an intake system (not illustrated). In Example, the center of the three suction units 53 is defined as a hand center D. The hand center D coincides with the center of the substrate W held by the hand unit 43 in plan view. The shape of the hand unit 43 is not limited to the shape illustrated in FIG. 5B.

In Example, the position of the hand unit 43 when the advance/retraction drive unit 44 is moved to the base end (right end of the groove 42 in FIG. 5B) of the groove 42 is set as a reference position of the hand unit 43. The state where the hand unit 43 has moved to the reference position is illustrated in FIGS. 9A and 9B. The position of the advance/retraction drive unit 44 in a state where the hand unit 43 has moved to the reference position is indicated by reference sign Bs in FIG. 5B and FIGS. 9A and 9B.

The rotary drive unit 45 is connected to a lower portion of the base unit 41. The rotary drive unit 45 rotates the base unit 41 around the vertical axis AX2. The rotation of the rotary drive unit 45 rotates the base unit 41 around the vertical axis AX2 together with the hand unit 43. That is, the direction of the hand unit 43 and the directions R in which the groove 42 extends can be changed by the rotation of the rotary drive unit 45. FIGS. 5A to 5C illustrate a state in which the advance/retraction directions R of the hand unit 43 coincides with the x directions. The rotary drive unit 45 includes an electric motor.

The first moving mechanism 47 moves the rotary drive unit 45 in the x direction. This can move the base unit 41 and the hand unit 43 in the x direction. The second moving mechanism 48 moves the rotary drive unit 45 in the up/down direction (z direction). This can move the base unit 41 and the hand unit 43 in the z direction. Each of the first moving mechanism 47 and the second moving mechanism 48 includes an electric motor. The first moving mechanism 47 and the second moving mechanism 48 may be provided on the floor of the conveyance space 17. The configuration including the base unit 41, the rotary drive unit 45, the first moving mechanism 47, and the second moving mechanism 48 holds the hand unit 43 such that the hand unit can move in the x direction and the z direction. The base unit 41, the rotary drive unit 45, the first moving mechanism 47, and the second moving mechanism 48 correspond to a movable table in the present invention.

As illustrated in FIG. 6, the substrate conveyance apparatus 10 according to Example includes a pair of imaging units 55. As illustrated in FIG. 5A and the like, the pair of imaging units 55 is disposed in the substrate conveyance mechanism TM1. The pair of imaging units 55 is disposed at a predetermined interval in a direction intersecting the advance/retraction directions R of the hand unit 43. In Example, the pair of imaging units 55 is disposed on both sides of the substrate conveyance mechanism TM1. One of the pair of imaging units 55 is defined as an imaging unit 55A, and the other is defined as an imaging unit 55B to distinguish the two.

In Example, the imaging unit 55A is disposed on the left side surface of the substrate conveyance mechanism TM1 (the lower side of the substrate conveyance mechanism TM1 in FIG 5B). The imaging unit 55B is disposed on the right side surface of the substrate conveyance mechanism TM1 (the upper side of the substrate conveyance mechanism TM1 in FIG 5B). The imaging unit 55A and the imaging unit 55B are arranged in parallel along a shorter direction of the base unit 41. In other words, the pair of imaging units 55 is disposed such that the straight line connecting the imaging unit 55A and the imaging unit 55B is parallel to the shorter direction of the base unit 41. Each of the imaging unit 55A and the imaging unit 55B is disposed on the rear portion (right side in FIG. 5A) of the side surface of the base unit 41 so that the hand unit 43 can be reliably imaged.

The pair of imaging units 55 is also disposed in each of the substrate conveyance mechanisms TR1 to TR5. In the substrate conveyance mechanisms TR1 to TR5, the imaging unit 55 is disposed in the rotary drive unit 14. That is, in the substrate conveyance mechanisms TR1 to TR5, the imaging unit 55 is configured not to move with the movement of the hand 13, but to move with the movement of the rotary drive unit 14 and the movement of the lifting drive unit 15.

Each of the imaging unit 55A and the imaging unit 55B includes a connection member 57 and a camera 59. That is, the substrate conveyance mechanism TM1 includes two cameras 59. The connection member 57 connects the substrate conveyance mechanism TM1 and the camera 59. One end side of the connection member 57 is connected to the base unit 41 of the substrate conveyance mechanism TM1. The other end side of the connection member 57 is connected to the camera 59. That is, the camera 59 is connected to the base unit 41 via the connection member 57.

Each of the two cameras 59 includes a lens 60, an image sensor (not illustrated), an image acquisition unit 61, and a communication unit 63. The lens 60 is disposed facing the front of the hand unit 43 (left side in FIG. 5A). An imaging direction of the camera 59 with the lens 60 is indicated by reference sign Fs in FIG. 5A and the like. That is, the lens 60 is disposed so as to be able to capture an image of a region including the hand unit 43 and a space in front of the hand unit 43. In Example, the orientation of the lens 60 is set such that the imaging direction Fs is parallel to the longer direction of the base unit 41.

The image sensor includes an imaging element such as a complementary metal oxide semiconductor (CMOS). The image sensor detects light condensed by the lens 60 and transmits a light detection signal. The image acquisition unit 61 performs various types of image processing based on the light detection signal of the image sensor, and acquires an optical image of a region including the hand unit 43 and a space in front of the hand unit 43. The communication unit 63 transmits the data of the optical image acquired by the image acquisition unit 61 to a control unit 65 described later. That is, the communication unit 63 transmits the data of the optical image to the outside of the imaging unit 55. A system in which the communication unit 63 communicates image data may be either a wired system or a wireless system.

The pair of imaging units 55 is configured to simultaneously capture images of the region including the hand unit 43 a space in front of the hand unit 43. By the pair of imaging units 55 simultaneously capturing images, the image acquisition unit 61 acquires a first optical image 81 generated based on the light condensed by the lens 60 of the imaging unit 55A and a second optical image 82 generated based on the light condensed by the lens 60 of the imaging unit 55B.

The first optical image 81 is an optical image obtained by capturing an image of a region including the hand unit 43 and a space in front of the hand unit 43 from one side surface of the substrate conveyance mechanism TM1. The second optical image 82 is an optical image obtained by capturing an image of a region including the hand unit 43 and a space in front of the hand unit 43 from the other side surface of the substrate conveyance mechanism TM1. Then, the communication unit 63 transmits the first optical image 81 and the second optical image 82 to the control unit 65. That is, the pair of imaging units 55 functions as a stereo camera.

The pair of imaging units 55 is also disposed in each of the substrate conveyance mechanisms TR1 to TR5. The pair of imaging units 55 is disposed so as not to move with the advancing and retracting movement of the hand 13, but to move with the rotational movement of the rotary drive unit 14 and the lifting and lowering movement of the lifting drive unit 15. As an example, the pair of imaging units 55 is disposed on both sides of the rotary drive unit 14.

As illustrated in FIG. 6, the substrate processing apparatus 1 further includes the control unit 65, an operation unit 67, and a storage unit 69. The control unit 65 includes an information processing unit such as a central processing unit (CPU). The control unit 65 integrally controls operation of each unit constituting the substrate processing apparatus 1.

The control unit 65 includes a drive control unit 71 that controls the advance/retraction drive unit 44. The drive control unit 71 transmits a signal related to a direction and a distance in which the advance/retraction drive unit 44 should move with respect to the R directions. The advance/retraction drive unit 44 advances and retracts in the R directions in accordance with a signal transmitted from the drive control unit 71.

The operation unit 67 includes a display unit that displays various types of information and an input unit that accepts an input operation. Examples of the display unit include a liquid crystal monitor. Examples of the input unit include a keyboard, a mouse, a touch panel, various buttons, and a combination thereof. Information on the input operation accepted by the operation unit 67 is transmitted to the control unit 65. The control unit 65 is configured to be able to integrally control the operation of each unit constituting the substrate processing apparatus 1 according to the input operation accepted by the operation unit 67.

The storage unit 69 includes, as an example, a storage medium such as a read-only memory (ROM), a random-access memory (RAM), or a hard disk. The storage unit 69 stores various conditions related to the processing of the substrate W, an operation program necessary for controlling the substrate processing apparatus 1, and the like. In addition, information on an advancing amount P1 is stored in advance in the storage unit 69. The storage unit 69 may be included in the control unit 65.

The advancing amount P1 is information related to a distance by which the hand unit 43 advances in the R directions with the advance/retraction drive unit 44. The advancing amount P1 is determined in advance as a distance for moving the hand unit 43 in the R directions to move the hand unit 43 from the reference position Bs to an advanced position Cs to be described later. That is, the information of the advancing amount P1 is information transmitted from the drive control unit 71 to the advance/retraction drive unit 44. Examples of the advancing amount P1 include 400 mm.

The substrate conveyance apparatus 10 further includes a position calculation unit 73, a correction coefficient calculation unit 74, a calibration unit 75, and a position storage unit 76. In Example, each of the position calculation unit 73, the correction coefficient calculation unit 74, the calibration unit 75, and the position storage unit 76 is provided in the control unit 65.

The position calculation unit 73 calculates the position of the subject of imaging with respect to the imaging unit 55 using the image of the subject of imaging captured by the imaging unit 55. That is, the position calculation unit 73 calculates the position of the subject of imaging with respect to the imaging unit 55 based on the first optical image 81 and the second optical image 82 transmitted from the communication unit 63. The first optical image 81 and the second optical image 82 are images of the hand unit 43 and a region in front of the hand unit 43 as the subjects of imaging. Thus, the position calculation unit 73 calculates the distance from the imaging unit 55 to the hand unit 43 as a relative distance K based on the first optical image 81 and the second optical image 82. The distance (relative distance K) from the imaging unit 55 to the hand unit 43 is calculated for each of the x direction, the y direction, and the z direction. That is, the position calculation unit 73 calculates the relative distance K based on the first optical image 81 captured by the camera 59 of the imaging unit 55A and the second optical image 82 photographed by the camera 59 of the imaging unit 55B.

When the first optical image 81 and the second optical image 82 in which the conveyance target object appears are transmitted from the communication unit 63, the position calculation unit 73 calculates the distance from the imaging unit 55 to the conveyance target object as a target object distance G. As an example, when the conveyance target object is the substrate placement unit PS1, the position calculation unit 73 calculates the distance from the imaging unit 55 to the substrate placement unit PS1 as the target object distance G based on the first optical image 81 and the second optical image 82 in which the substrate placement unit PS1 appears.

In addition, the position calculation unit 73 calculates a necessary moving amount E based on information such as the target object distance G. The necessary moving amount E corresponds to a moving amount estimated to be necessary for the substrate conveyance apparatus to move from the current position as a starting point to the target position of the conveyance target object. The necessary moving amount E is calculated for each of the x direction, the y direction, and the z direction. That is, the necessary moving amount E corresponds to information for specifying the three-dimensional position of the conveyance target object. The necessary moving amount E corresponds to target object positional information in the present invention. The position calculation unit 73 corresponds to a target object position calculation unit in the present invention.

The position calculation unit 73 further calculates an estimated moving amount L1 of the hand unit 43 based on the relative distance K calculated in a state where the hand unit 43 has moved to the reference position Bs and the relative distance K calculated in a state where the hand unit 43 has moved to the advanced position Cs. The estimated moving amount L1 corresponds to a value estimated as the distance that the hand unit 43 has moved from the reference position Bs to the advanced position Cs based on the image data acquired by the imaging unit 55. The position calculation unit 73 corresponds to an estimated moving amount calculation unit in the present invention.

The correction coefficient calculation unit 74 calculates a correction coefficient Mk based on the value of the advancing amount P1 transmitted by the drive control unit 71 and the value of the estimated moving amount L1 calculated by the position calculation unit 73. The correction coefficient Mk is a coefficient for correcting a difference between the advancing amount P1 and the estimated moving amount L1. The calibration unit 75 calculates the calibrated moving amount H by calibrating the information of the necessary moving amount E calculated by the position calculation unit 73 based on the correction coefficient Mk. The calibrated moving amount H is calculated for each of the x direction, the y direction, and the z direction. A specific calibration method will be described later.

The position storage unit 76 includes a storage medium such as a read-only memory (ROM) and a random-access memory (RAM). The position storage unit 76 stores information of the calibrated moving amount H calculated by the calibration unit 75. The calibrated moving amount H is such a value that the substrate conveyance mechanism TM1 moves by the target object distance G and accurately moves to the conveyance target object when the control unit 65 transmits a signal indicating an instruction to move according to the calibrated moving amount H. That is, the calibrated moving amount H is stored in the position storage unit 76 as a value of a moving distance by which the substrate conveyance mechanism TM1 can be accurately moved to the conveyance target object.

In Example, the substrate processing apparatus 1 further includes a notification unit 77. The notification unit 77 notifies that the absolute value of the difference between the advancing amount P1 and the estimated moving amount L1 is equal to or larger than a threshold P2 by using sound, light, characters, or the like. Examples of the notification unit 77 include a warning device that generates a warning sound and a display unit of the operation unit 67 that displays character information. The information of the threshold P2 is stored in advance in the storage unit 69. The operation of the notification unit 77 is controlled by the control unit 65 as an example.

<Overview of Substrate Processing Method>

An overview of the processing steps with respect to the substrate W performed using the substrate processing apparatus 1 is as follows. First, the substrate W is conveyed from the indexer block 2 to the coating block 3. That is, in the ID block 2, the substrate conveyance mechanism TR1 unloads the substrate W from the carrier C placed on the opener 7. The substrate conveyance mechanism TR1 places the substrate W unloaded from the carrier C onto the substrate placement unit PS1 (or the substrate placement unit PS2).

Next, the substrate conveyance mechanism TM1 disposed in the coating block 3 conveys the substrate W placed on the substrate placement unit PS1 (or the substrate placement unit PS2) to the liquid processing unit 19 of the coating block 3. Coating processing of applying a processing liquid, for example, a photoresist liquid, is performed on the substrate W conveyed to the liquid processing unit 19. After the coating processing is completed, the substrate conveyance mechanism TM1 conveys the substrate W subjected to the coating processing to the thermal processing unit 20. The substrate W conveyed to the thermal processing unit 20 is placed on the cooling plate 27 and subjected to cooling processing, and further placed on the heating plate 29 and subjected to heating processing.

After the thermal processing (cooling processing and heating processing) in the thermal processing unit 20 is completed, the substrate W is conveyed from the coating block 3 to the IF block 5. The substrate conveyance mechanism TM1 disposed in the coating block 3 conveys and places the substrate W onto the substrate placement unit PS3 (or the substrate placement unit PS4). The substrate conveyance mechanism TM1 disposed in the development block 4 holds the substrate W placed onto the substrate placement unit PS3 (or the substrate placement unit PS4), and conveys and places the substrate W on the substrate placement unit PS5 (or the substrate placement unit PS6). The substrate conveyance mechanisms TR3 and TR4 disposed in the IF block 5 hold the substrate W placed on the substrate placement unit PS5 (or the substrate placement unit PS6) and convey the substrate W to the pre-exposure cleaning unit 31, and pre-exposure cleaning processing is performed.

After the pre-exposure cleaning processing is completed, the substrate W is delivered to the substrate conveyance mechanism TR5 via the substrate placement unit PS7. The substrate conveyance mechanism TR5 conveys the substrate W from the IF block 5 to the exposure device EXP. The exposure device EXP performs exposure processing on the substrate W. After the exposure processing is completed, the substrate W is conveyed to the post-exposure cleaning unit SOAK of the IF block 5 by the substrate conveyance mechanisms TR3 to TR5, and the post-exposure cleaning processing is performed.

After the post-exposure cleaning processing is completed, the development processing or the like is performed in the development block 4. That is, the substrate conveyance mechanisms TR3 and TR4 disposed in the IF block 5 convey and place the substrate W onto the substrate placement unit PS5 (or the substrate placement unit PS6). The substrate conveyance mechanism TM1 disposed in the development block 4 conveys the substrate W placed on the substrate placement unit PS5 (or the substrate placement unit PS6) to the liquid processing unit 19 of the development block 4. The substrate W conveyed to the liquid processing unit 19 is subjected to development processing using a developing solution. After the development processing, the substrate conveyance mechanism TM1 of the development block 4 conveys the substrate W to the thermal processing unit 20 of the development block 4. The substrate W conveyed to the thermal processing unit 20 is placed on the cooling plate 27 and subjected to cooling processing, and further placed on the heating plate 29 and subjected to heating processing.

After the development processing and the thermal processing are completed in the development block 4, the substrate W is conveyed from the development block 4 to the ID block 2. The substrate W is conveyed via the substrate placement units PS1 to PS4 and delivered from the substrate conveyance mechanism TM1 to the substrate conveyance mechanisms TR1 and TR2. The substrate conveyance mechanisms TR1 and TR2 load the substrate W into the carrier C placed on the opener 8. Through the above steps, the processing steps with respect to the substrate W are completed.

When various processing steps are performed on the substrate W in the substrate processing apparatus 1, the substrate conveyance mechanisms TM1 and TR1 to TR5 convey the substrate W to the conveyance destination, and the operation of placing the substrate W onto the conveyance destination is repeatedly performed. Examples of the conveyance destination include the substrate placement units PS1 to PS7, the hold rotation unit of the liquid processing unit 19, and the heating plate 29 of the thermal processing unit 20. To improve the accuracy of various types of processing on the substrate W, it is required to improve the conveyance accuracy of the substrate W. That is, it is required that the substrate conveyance mechanisms TM1 and TR1 to TR5 accurately move to the target position in the conveyance destination and place the substrate W at the target position. Thus, it is necessary to teach the target position of each of a large number of conveyance destinations to each of the substrate conveyance mechanisms TM1 and TR1 to TR5 to eliminate the deviation of the actual target position from the target position in calculation.

<Description of Teaching Step>

Here, a series of steps of performing teaching using the substrate conveyance apparatus 10 in the substrate processing apparatus 1 according to Example will be described. FIG. 7 is a flowchart illustrating a series of steps of teaching in Example. Here, a case where the teaching is performed on the substrate conveyance mechanism TM1 disposed in the coating block 3 with the substrate placement unit PS1 set as the conveyance target object will be described as an example.

Step S1 (Movement of substrate conveyance mechanism)

When the step of teaching is started, the substrate conveyance mechanism TM1 is first moved to a predetermined position (execution position) for executing the teaching step. That is, the control unit 65 appropriately rotates the rotary drive unit 45 of the substrate conveyance mechanism TM1 such that the tips of the hand unit 43 face the substrate placement unit PS1. Further, the control unit 65 controls the first moving mechanism 47 and the second moving mechanism 48 to appropriately move the substrate conveyance mechanism TM1 in the x direction and the z direction.

Under the control of the control unit 65, the substrate conveyance mechanism TM1 moves to the execution position. The execution position of the substrate conveyance mechanism TM1 is determined in advance as a position close to the substrate placement unit PS1 such that the imaging unit 55 moved to the execution position can capture an image of the substrate placement unit PS1. The substrate conveyance mechanism TM1 is moved to the execution position, and the control unit 65 lifts each of the support pins 35 from the retraction position to the projection position. The substrate conveyance mechanism TM1 moves to the execution position, and the support pin 35 lifts to the projection position, whereby step S1 is completed. FIGS. 8A and 8B illustrate a state in which the substrate conveyance mechanism TM1 has moved to the execution position and step S1 has been completed. FIG. 8A is a front view illustrating a state in which step S1 is completed, and FIG. 8B is a plan view illustrating a state in which step S1 is completed.

Step S2 (Movement to reference position)

After the substrate conveyance mechanism TM1 is moved to the execution position and step S1 is completed, the step of moving the hand unit 43 to the reference position Bs starts. The drive control unit 71 included in the control unit 65 drives the advance/retraction drive unit 44 in the R direction so that the hand unit 43 moves to the reference position Bs. As illustrated in FIG. 5B and the like, the reference position Bs corresponds to the base end (right end in FIG. 5B) of the groove 42. In accordance with a control signal from the drive control unit 71, the advance/retraction drive unit 44 is driven in the R2 direction along the groove 42.

As the advance/retraction drive unit 44 moves in the R2 direction toward the base end of the groove 42, the advance/retraction drive unit 44 moves to the reference position Bs together with the hand unit 43. When the hand unit 43 moves to the reference position Bs, step S2 is completed. The direction in which the hand unit 43 moves in step S2 is indicated by reference sign M1 in FIG. 9A and the like. FIGS. 9A and 9B illustrate a state in which the hand unit 43 has moved to the reference position Bs and step S2 is completed. FIG. 9A is a front view illustrating a state in which step S2 is completed, and FIG. 9B is a plan view illustrating a state in which step S2 is completed.

In a state where the hand unit 43 has moved to the reference position Bs, the imaging direction Fs of the imaging unit 55 is illustrated in FIG. 9B and the like. The imaging direction Fs is a direction in which the lenses 60 of the imaging unit 55A and the imaging unit 55B face. The rotary drive unit 45 is rotated in advance in step S1 so that the imaging direction Fs faces a region including the hand unit 43, the base end placement unit PS1, and a region in front of the hand unit 43. Thus, in a state where step S2 is completed, the pair of imaging units 55 can capture an image of a region including the hand unit 43, the base end placement unit PS1, and a space in front of the hand unit 43. In other words, in a state where step S2 is completed, the pair of imaging units 55 can capture an image of the hand unit 43 and the substrate placement unit PS1.

Step S3 (Capturing of an image of hand unit at reference position)

After the hand unit 43 is moved to the reference position Bs, a step of capturing an image of the hand unit 43 moved to the reference position Bs starts. The control unit 65 controls the pair of imaging units 55 to capture an image of the hand unit 43 and a region including a space in front of the hand unit 43. When the control unit 65 operates the pair of imaging units 55, in each of the imaging unit 55A and the imaging unit 55B, light condensed by the lens 60 facing the imaging direction Fs is detected by the image sensor. Each image sensor transmits a light detection signal based on the detected optical information. The light detection signal transmitted by each of the image sensors is transmitted to the image acquisition unit 61.

The image acquisition unit 61 performs various types of image processing based on the light detection signal transmitted by the image sensor of the imaging unit 55A, and acquires the first optical image 81. The image acquisition unit 61 performs various types of image processing based on the light detection signal transmitted by the image sensor of the imaging unit 55B, and acquires the second optical image 82 (reference image acquisition step). FIG. 10 illustrates the first optical image 81 and the second optical image 82 captured in step S3.

The first optical image 81 corresponds to an image obtained by capturing an image of the hand unit 43 and a region in front of the hand unit from the left side surface of the substrate conveyance mechanism TM1. The second optical image 82 corresponds to an image obtained by capturing an image of the hand unit 43 and a region in front of the hand unit from the right side surface of the substrate conveyance mechanism TM1. In other words, the hand unit 43 captured by the imaging unit 55A appears in the first optical image 81. The hand unit 43 captured by the imaging unit 55B appears in the second optical image 82.

Of the first optical image 81 and the second optical image 82 acquired by the image acquisition unit 61, images in which the hand unit 43 moved to the reference position Bs appears is referred to as a first optical image 81A and a second optical image 82A. That is, in step S3, the pair of imaging units 55 captures an image of the hand unit 43 at the reference position Bs to acquire the first optical image 81A and the second optical image 82A. The first optical image 81A and the second optical image 82A correspond to a reference image in the present invention. The image acquisition unit 61 corresponds to a reference image acquisition unit in the present invention.

For convenience of description, the description of the image of the substrate placement unit PS1 is omitted even when an image of the substrate placement unit PS1 appears in the first optical image 81A and the second optical image 82A. The first optical image 81 and the second optical image 82 in which the hand unit 43 moved to the reference position Bs and a region in front of the hand unit appear are acquired using the pair of imaging units 55, whereby step S3 is completed.

Step S4 (Calculation of reference distance)

After the two optical images 81 and 82 in which the hand unit 43 at the reference position Bs appears are acquired, a step of calculating a reference distance K1 starts. In step S4, the relative distance K with respect to the hand unit 43 at the reference position Bs is calculated as the reference distance K1. When step S4 is started, the data of the first optical image 81 and the second optical image 82 acquired by the image acquisition unit 61 in step S3 is transmitted to the communication unit 63. The communication unit 63 transmits the data of the first optical image 81 and the second optical image 82 to the control unit 65. That is, the data of the first optical image 81A and the second optical image 82A is transmitted to the outside of the imaging unit 55 by the communication unit 63, and is received by the position calculation unit 73 of the control unit 65 or the like.

The position calculation unit 73 extracts the reference point of the hand unit 43 for each of the first optical image 81A and the second optical image 82A. In Example, the hand center D, which is the center of the hand unit 43, is set as the reference point of the hand unit 43 (see FIG. 5B).

A method for extracting the hand center D from the optical image in Example is as follows. That is, the position calculation unit 73 extracts the three suction units 53 as the feature points of the hand unit 43. The position calculation unit 73 extracts the three suction units 53 from each of the first optical image 81A and the second optical image 82A by using a method such as pattern matching for each of the first optical image 81A and the second optical image 82A. Then, the position calculation unit 73 extracts a region corresponding to the center of the three suction units 53 as the hand center D which is a reference point. Of the hand centers D, the hand center D of the hand unit 43 that has moved to the reference position Bs will be hereinafter referred to as "hand center Dt" to be distinguished from the hand center D of the hand unit 43 that has moved to another position.

FIG. 11A is a diagram illustrating the three suction units 53 and the hand center Dt extracted in the first optical image 81A. FIG. 11B is a diagram illustrating the three suction unit 53 and the hand center Dt extracted in the second optical image 82A. The hand center Dt extracted from the first optical image 81A is defined as a hand center DtL. The hand center Dt extracted from the second optical image 82A is defined as a hand center DtR.

In the pair of imaging units 55, the position where the lens 60 of the imaging unit 55A is disposed and the position where the lens 60 of the imaging unit 55B is disposed are different in the right-and-left direction of the substrate conveyance mechanism TM1 (the shorter direction of the base unit 41). Thus, the position where the hand center DtL appears in the first optical image 81 is different from the position where the hand center DtR appears in the second optical image 82. In other words, a parallax Nd is generated between the hand center DtL and the hand center DtR. FIG. 11C illustrates the parallax Nd between the hand center DtL appearing in the first optical image 81A and the hand center DtR appearing in the second optical image 82A in a case where an image of the hand unit 43 moved to the reference position Bs is captured. The position calculation unit 73 can calculate the parallax Nd between the hand center DtL and the hand center DtR by extracting the hand centers DtL and DtR.

The position calculation unit 73 further calculates the distance from the imaging unit 55 to the hand unit 43 as the relative distance K using the parallax Nd. In Example, the distance between the camera 59 of the imaging unit 55A and the camera 59 of the imaging unit 55B is defined as a camera distance T1. The focal length of the camera 59 in the pair of imaging units 55 is defined as a focal length T2. In this case, using the camera distance T1, the focal length T2, and the parallax Nd, the relative distance K can be calculated using the following mathematical expression (A).

$$K = (T1 \cdot T2)/Nd \quad \ldots \ldots \quad (A)$$

That is, the relative distance K is calculated by dividing the product of the camera distance T1 and the focal length T2 by the parallax Nd. As illustrated in FIG. 12A, the relative distance K corresponds to the distance from an intersection line 79 connecting the pair of imaging units 55 to the hand center Dt. That is, a line connecting the lens 60 of the imaging unit 55A and the lens 60 of the imaging unit 55B corresponds to the intersection line 79. When a line passing through the hand center Dt and orthogonal to the intersection line 79 is defined as a normal line 80, and a point at which the normal line 80 and the intersection line 79 intersect is defined as an intersection point V, the distance from the intersection point V to the hand center Dt corresponds to the relative distance K. The relative distance K calculated for the hand unit 43 moved to the reference position Bs is defined as the reference distance K1. The reference distance K1 corresponds to reference positional information in the present invention. The position calculation unit 73 corresponds to a reference position calculation unit in the present invention.

By calculating the relative distance K, the position of the hand center Dt in a depth direction of the optical images 81 and 82 can be obtained. The position of the hand center Dt in the planar direction (the right-and-left direction and the up/down direction) of the optical images 81 and 82 is already known at the time of acquiring the optical images 81 and 82 in which the hand center Dt appears. The three-dimensional position of each component constituting the imaging unit 55A and the imaging unit 55B is known in advance. Thus, by calculating the relative distance K, the three-dimensional position of the hand center Dt with respect to the imaging unit 55 can be obtained. As an example, as illustrated in FIG. 12B, the distance to the hand center Dt of the hand unit 43 at the reference position Bs with reference to the lens 60 of the imaging unit 55A can be calculated as a three-dimensional distance S.

The three-dimensional distance S includes three components of a distance Sx in the x direction, a distance Sy in the y direction, and a distance Sz in the z direction. That is, when the moving distance in the x direction is the distance Sx, the moving distance in the y direction is the distance Sy, and the moving distance in the z direction is the distance Sz with the lens 60 of the imaging unit 55A as a starting point, the position of the lens 60 of the imaging unit 55A shifts to the position of the hand center Dt of the hand unit 43 at the reference position Bs.

The position calculation unit 73 can calculate the three-dimensional distance S from the lens 60 of the imaging unit 55A to the hand center Dt of the hand unit 43 at the reference position Bs based on the relative distance K1. The position calculation unit 73 calculates the relative distance K (reference distance K1) of the hand unit 43 moved to the reference position Bs, whereby step S4 is completed. Step S4 corresponds to a reference distance calculation step in the present invention.

Step S5 (Movement to advanced position)

When the relative distance K of the hand unit 43 at the reference position Bs is calculated as the reference distance K1, a step of moving the hand unit 43 from the reference position Bs to the advanced position Cs starts. When step S5 is started, the drive control unit 71 included in the control unit 65 controls the advance/retraction drive unit 44 such that the hand unit 43 advances from the reference position Bs to the advanced position Cs. That is, the drive control unit 71 transmits, to the advance/retraction drive unit 44, a control signal indicating movement by a distance corresponding to the advancing amount P1 from the reference position Bs in the R1 direction.

The advance/retraction drive unit 44 moves in the R1 direction along the groove 42 according to the control signal. With the movement of the advance/retraction drive unit 44, the hand unit 43 moves in the R1 direction together with the advance/retraction drive unit 44. That is, as a result of the control of the drive control unit 71 in step S5, the hand unit 43 moves from the reference position Bs to the advanced position Cs. When the hand unit 43 has moved from the reference position Bs to the advanced position Cs, step S5 is completed. FIGS. 13A and 13B illustrate a state in which the hand unit 43 has moved from the reference position Bs to the advanced position Cs and step S5 is completed. FIG. 13A is a front view illustrating a state in which step S5 is completed, and FIG. 13B is a plan view illustrating a state in which step S5 is completed.

The pair of imaging units 55 is configured not to be synchronized with the movement of the hand unit 43. Thus, the imaging direction Fs of the imaging unit 55 does not change even when the hand unit 43 moves from the reference position Bs to the advanced position Cs. The position of the imaging unit 55 does not change even when the hand unit 43 moves from the reference position Bs to the advanced position Cs. Thus, in a state where step S5 is completed, the pair of imaging units 55 can capture an image of a region including the hand unit 43, the base end placement unit PS1, and a space in front of the hand unit 43. Step S5 is completed when the hand unit 43 has moved from the reference position Bs to the advanced position Cs.

Step S6 (Capturing image of hand unit at advanced position)

After the hand unit 43 is moved to the advanced position Cs, a step of capturing an image of the hand unit 43 moved to the advanced position Cs starts. The control unit 65 controls the pair of imaging units 55 to capture an image of the hand unit 43 and a region including a space in front of the hand unit 43. When the control unit 65 operates the pair of imaging units 55, in each of the imaging unit 55A and the imaging unit 55B, light condensed by the lens 60 facing the imaging direction Fs is detected by the image sensor. Each image sensor transmits a light detection signal based on the detected optical information. The light detection signal transmitted by each of the image sensors is transmitted to the image acquisition unit 61.

The image acquisition unit 61 performs various types of image processing based on the light detection signal transmitted by the image sensor of the imaging unit 55A, and acquires the first optical image 81. The image acquisition unit 61 performs various types of image processing based on the light detection signal transmitted by the image sensor of the imaging unit 55B, and acquires the second optical image 82 (advanced image acquisition step). FIG. 14 illustrates the first optical image 81 and the second optical image 82 captured in step S6.

Of the first optical image 81 and the second optical image 82 acquired by the image acquisition unit 61, an image in which the hand unit 43 moved to the advanced position Cs appears is referred to as first optical image 81B and second optical image 82B. That is, in step S6, the hand unit 43 at the advanced position Cs is captured by the pair of imaging units 55 to acquire the first optical image 81B and the second optical image 82B. For convenience of description, even when an image of the substrate placement unit PS1 appears in the first optical image 81B and the second optical image 82B, the description of the image of the substrate placement unit PS1 is omitted. The first optical image 81B and the second optical image 82B correspond to the advanced image in the present invention. The image acquisition unit 61 corresponds to an advanced image acquisition unit in the present invention.

In step S3, an image of the hand unit 43 moved to the reference position Bs relatively close to the imaging unit 55 is captured. Thus, in the first optical image 81A acquired in step S3, the hand unit 43 appears on the front side. On the other hand, in step S6, an image of the hand unit 43 moved to the advanced position Cs relatively far from the imaging unit 55 is captured. Thus, in the first optical image 81B acquired in step S6, the hand unit 43 appears on the far side as compared with the first optical image 81A. Similarly, the position of the hand unit 43 appearing in the first optical image 81B is on the far side as compared with the position of the hand unit 43 appearing in the first optical image 81A. The first optical image 81 and the second optical image 82 in which the hand unit 43 moved to the advanced position Cs and a region in front of the hand unit appear are acquired using the pair of imaging units 55, whereby step S6 is completed.

Step S7 (Calculation of advanced distance)

After the two optical images 81 and 82 in which the hand unit 43 at the advanced position Cs appears are acquired, a step of calculating an advanced distance K2 starts. In step S4, the relative distance K with respect to the hand unit 43 at the advanced position Cs is calculated as the advanced distance K2. When step S7 is started, the data of the first optical image 81 and the second optical image 82 acquired by the image acquisition unit 61 in step S6 is transmitted to the position calculation unit 73 of the control unit 65 via the communication unit 63.

Similarly to step S3, the position calculation unit 73 extracts the hand center D as the reference point of the hand unit 43 for each of the first optical image 81B and the second optical image 82B.

That is, the position calculation unit 73 extracts three suction units 53 from each of the first optical image 81B and the second optical image 82B by using a method such as pattern matching for each of the first optical image 81B and the second optical image 82B. Then, the position calculation unit 73 extracts a region corresponding to the center of the three suction units 53 as the hand center D. Of the hand centers D, the hand center D of the hand unit 43 moved to the advanced position Cs will be hereinafter referred to as "hand center Ds" to be distinguished from the hand center Dt.

FIG. 15A is a diagram illustrating the three suction units 53 and the hand center Ds extracted in the first optical image 81B. FIG. 15B is a diagram illustrating the three suction units 53 and the hand center Ds extracted in the second optical image 82B. The hand center Ds extracted from the first optical image 81A is defined as a hand center DsL. The hand center Ds extracted from the second optical image 82B is defined as a hand center DsR.

The position of the imaging unit 55A and the position of the imaging unit 55B are different in the right-and-left direction of the substrate conveyance mechanism TM1. Thus, the parallax Nd is also generated between the hand center DsL and the hand center DsR. FIG. 15C illustrates the parallax Nd between the hand center DsL appearing in the first optical image 81B and the hand center DsR appearing in the second optical image 82B when the hand unit 43 moved to the advanced position Cs is captured. The position calculation unit 73 can calculate the parallax Nd between the hand center DsL and the hand center DsR by extracting the hand centers DsL and DsR.

The position calculation unit 73 further calculates the distance from the imaging unit 55 to the hand unit 43 as the relative distance K using the parallax Nd between the hand center DsL and the hand center DsR. The mathematical expression for calculating the relative distance K in step S6 is the same as that in step S3. That is, the product of the camera distance T1 and the focal length T2 is divided by the parallax Nd between the hand center DsL and the hand center DsR, whereby the relative distance K from the imaging unit 55 to the hand unit 43 at the advanced position Cs is calculated. The relative distance K calculated for the hand unit 43 moved to the advanced position Cs is defined as an advanced distance K2. The advanced distance K2 corresponds to advanced positional information in the present invention. The position calculation unit 73 corresponds to an advanced position calculation unit in the present invention.

As illustrated in FIG. 16A, the advanced distance K2 corresponds to the distance from the intersection line 79 to the hand center Ds. In other words, the distance from the intersection point V between the normal line 80 and the intersection line 79 to the hand center Ds corresponds to the advanced distance K2. In FIG. 16A and FIG. 16B or the like described later, description of the groove 42 is appropriately omitted for convenience of description. Step S7 corresponds to an advanced distance calculation step in the present invention.

Step S8 (Calculation of estimated moving amount)

After the reference distance K1 and the advanced distance K2 are calculated, a step of calculating the estimated moving amount **L1** of the hand unit 43 starts. The estimated moving amount **L1** is a value estimated as a distance that the hand unit 43 has moved from the reference position Bs to the advanced position Cs based on the image data acquired by the imaging unit 55.

When the relative distance K2 is calculated, the estimated moving amount L1 is calculated using the relative distance K1 already calculated in step S3 and the relative distance K2. That is, the position calculation unit 73 calculates the estimated moving amount L1 by using the following mathematical expression (B).

$$L1 = K2 - K1 \ldots \ldots (B)$$

FIG. 16B is a plan view illustrating a positional relationship between the hand center Dt and the hand center Ds based on the image data, and a relationship between the relative distance K1 and the relative distance K2. The estimated moving amount L1 is a value estimated to be the distance that the hand unit 43 has moved from the reference position Bs to the advanced position Cs based on the data of the image captured by the imaging unit 55.

The distance that the hand unit 43 has moved from the reference position Bs to the advanced position Cs corresponds to the distance from the hand center Dt related to the reference position Bs to the hand center Ds related to the advanced position Cs. That is, the estimated moving amount L1 corresponds to the distance from the hand center Dt to the hand center Ds as illustrated in FIG. 15A and the like. The reference distance K1 corresponds to the distance from the imaging unit 55 to the hand center Dt. The advanced distance K2 corresponds to the distance from the imaging unit 55 to the hand center Ds. Thus, by calculating the difference between the advanced distance K2 and the reference distance K1, the position calculation unit 73 can calculate the estimated moving amount L1. By calculating the estimated moving amount L1, step S8 is completed. Step S8 corresponds to an estimated moving amount calculation step in the present invention.

Step S9 (Calculation of correction coefficient)

When the estimated moving amount L1 is calculated and step S8 is completed, a step of calculating the correction coefficient Mk starts. The information on the estimated moving amount L1 calculated by the position calculation unit 73 is transmitted to the correction coefficient calculation unit 74. The information on the advancing amount P1 related to the control of the drive control unit 71 is also transmitted from the storage unit 69 to the correction coefficient calculation unit 74. The correction coefficient calculation unit 74 calculates the correction coefficient Mk using the value of the estimated moving amount L1 and the value of the advancing amount P1. In Example, the correction coefficient Mk is calculated using the following mathematical expression (C).

$$Mk = P1/L1 \ldots \ldots (C)$$

The correction coefficient Mk is used in a subsequent step as a coefficient for correcting the difference between the estimated moving amount L1 and the advancing amount P1. In other words, the correction coefficient Mk corrects a difference between the numerical value indicated as the movement distance by the control unit 65 and the numerical value of the movement distance assumed based on the optical images 81 and 82 with respect to the information of the distance calculated from the optical images 81 and 82. In Example, the correction coefficient Mk is calculated as a ratio between the advancing amount P1 and the estimated moving amount L1. The information on the correction coefficient Mk is transmitted from the correction coefficient calculation unit 74 to the calibration unit 75. When the correction coefficient Mk is calculated, step S9 is completed. Step S9 corresponds to a correction coefficient calculation step in the present invention.

When step S9 is completed, the processing is branched based on the difference (P1 - L1) between the advancing amount P1 and the estimated moving amount L1 (see option Q1 in FIG. 7). The control unit 65 calculates the absolute value (|P1 - L1|) of the difference between the advancing amount P1 and the estimated moving amount L1, and compares the absolute value with the threshold P2. When the absolute value (|P1 - L1|) is equal to or larger than the threshold P2 (when the option Q1 is "Yes"), the processing proceeds to step S14. When the absolute value (|P1 - L1|) is less than the threshold P2 (when the option Q1 is "No"), the processing proceeds to step S10. Here, the processing after step S10 will be described assuming that the option Q1 is "No". The processing based on option Q1 may be branched after step S8.

Step S10 (Capture image of conveyance target object)

When step S10 is started, imaging of the substrate placement unit PS1 as a conveyance target object starts. The control unit 65 controls the pair of imaging units 55 to capture an image of the substrate placement unit PS1 present in the space in front of the hand unit 43. When the control unit 65 operates the pair of imaging units 55, in each of the imaging unit 55A and the imaging unit 55B, light condensed by the lens 60 facing the imaging direction Fs is detected by the image sensor. Each image sensor transmits a light detection signal based on the detected optical information. The light detection signal transmitted by each of the image sensors is transmitted to the image acquisition unit 61.

The image acquisition unit 61 performs various types of image processing based on the light detection signal transmitted by the image sensor of the imaging unit 55A, and acquires the first optical image 81. The image acquisition unit 61 performs various types of image processing based on the light detection signal transmitted by the image sensor of the imaging unit 55B, and acquires the second optical image 82. FIG. 17 illustrates the first optical image 81 and the second optical image 82 captured in step S8.

Of the first optical image 81 and the second optical image 82 acquired by the image acquisition unit 61, an image in which the substrate placement unit PS1 appears is referred to as first optical image 81C and second optical image 82C. That is, in step S10, an image of the substrate placement unit PS1 in front of the hand unit 43 is captured by the pair of imaging units 55 to acquire the first optical image 81C and the second optical image 82C (target object image acquisition step). The first optical image 81C and the second optical image 82C correspond to the target object image in the present invention. The image acquisition unit 61 corresponds to a target object image acquisition unit in the present invention.

For convenience of description, the description of the image of the hand unit 43 is omitted even when the image of the hand unit 43 appears in the first optical image 81C and the second optical image 82C. When the first optical image 81 and the second optical image 82 in which the substrate placement unit PS1 appears are acquired, step S10 is completed.

Step S11 (Calculation of target object positional information)

After the two optical images 81 and 82 in which the substrate placement unit PS1 appears are acquired, a step of calculating the target object distance G for the substrate placement unit PS1 starts. The target object distance G corresponds to the distance from the imaging unit 55 to the substrate placement unit PS1. When step S11 is started, the data of the first optical image 81C and the second optical image 82C acquired by the image acquisition unit 61 in step S10 is transmitted to the communication unit 63. The communication unit 63 transmits the data of the first optical image 81C and the second optical image 82C to the control unit 65. That is, the data of the first optical image 81C and the second optical image 82C is transmitted to the outside of the imaging unit 55 by the communication unit 63, and is received by the position calculation unit 73 of the control unit 65 or the like.

The position calculation unit 73 extracts the reference point of the substrate placement unit PS1 for each of the first optical image 81C and the second optical image 82C. In Example, the pin center Pk, which is the center of the three support pins 35, is set as the reference point of the substrate placement unit PS1 (see FIG. 4C).

In Example, a method for extracting the pin center Pk from the optical image is as follows. That is, the position calculation unit 73 extracts a feature point from each of the optical images 81C and 82C as a preliminary step for specifying the reference point of the substrate placement unit PS1. In Example, the position calculation unit 73 extracts a vertex part 83 of each of the three support pins 35 as the feature point of the substrate placement unit PS1. The position calculation unit 73 extracts three vertex parts 83 from each of the first optical image 81C and the second optical image 82C using a method such as pattern matching for each of the first optical image 81C and the second optical image 82C. Then, the position calculation unit 73 extracts the region corresponding to the center of the three vertex parts 83 as the pin center Pk.

FIG. 18A is a diagram illustrating the three vertex parts 83 and the pin center Pk extracted in the first optical image 81C. FIG. 18B is a diagram illustrating the three vertex parts 83 and the pin center Pk extracted in the second optical image 82C. The pin center Pk extracted from the first optical image 81C is defined as a pin center PkL. The pin center Pk extracted from the second optical image 82C is defined as a pin center PkR.

In the pair of imaging units 55, the position where the lens 60 of the imaging unit 55A is disposed and the position where the lens 60 of the imaging unit 55B is disposed are different in the right-and-left direction of the substrate conveyance mechanism TM1 (the shorter direction of the base unit 41). Thus, the position where the pin center PkL appears in the first optical image 81C is different from the position where the pin center PkR appears in the second optical image 82C. In other words, the parallax Nd is generated between the pin center PkL and the pin center PkR. FIG. 18C illustrates the parallax Nd between the pin center PkL appearing in the first optical image 81C and the pin center PkR appearing in the second optical image 82C. The position calculation unit 73 can calculate the parallax Nd between the pin center PkL and the pin center PkR by extracting the pin centers PkL and PkR.

The position calculation unit 73 further calculates the distance from the imaging unit 55 to the substrate placement unit PS1 as the target object distance G using the parallax Nd between the pin center PkL and the pin center PkR. The mathematical expression for calculating the target object distance G in step S9 is the same as the mathematical expression for calculating the relative distance K in step S3 and the like. That is, the product of the camera distance T1 and the focal length T2 is divided by the parallax Nd between the pin center PkL and the pin center PkR, whereby the target object distance G from the imaging unit 55 to the substrate placement unit PS1 is calculated.

Strictly speaking, the target object distance G calculated in Example corresponds to the distance from the imaging units 55 to the pin center Pk. That is, as illustrated in FIG. 19A, the target object distance G corresponds to the distance from the intersection line 79 connecting the pair of imaging units 55 to the pin center Pk. Assuming that a line passing through the pin center Pk and orthogonal to the intersection line 79 is a normal line 86, and that a point at which the normal line 86 and the intersection line 79 intersect is an intersection point V2, the distance from the intersection point V2 to the pin center Pk corresponds to the target object distance G.

When the substrate W is delivered to the support pins 35 of the substrate placement unit PS1 by lifting the support pins 35 to the projection position, the center of the substrate W coincides with the pin center Pk. The hand center D of the hand unit 43 coincides with the center of the substrate W held by the hand unit 43 of the substrate conveyance mechanism TM1. Thus, when the substrate placement unit PS1 is the conveyance target object, the pin center Pk of the substrate placement unit PS1 corresponds to the target position of the substrate conveyance mechanism TM1. In other words, when the substrate conveyance mechanism TM1 conveys the substrate W to the substrate placement unit PS1, it is necessary to drive the hand unit 43 and the first moving mechanism 47 of the substrate conveyance mechanism TM1 so that the hand center D of the hand unit 43 coincides with the pin center Pk.

To make the hand center D coincide with the pin center Pk with high accuracy, accurate information is required for three of the movement distance in the x direction, the movement distance in the y direction, and the movement distance in the z direction from the hand center D of the hand unit 43 to the pin center Pk which is the target position. As an example, when the hand unit 43 has currently moved to the advanced position Cs, three pieces of information of the movement distance in the x direction, the movement distance in the y direction, and the movement distance in the z direction from the hand center Ds to the pin center Pk are required to move the hand unit 43 moved to the advanced position Cs to the pin center Pk.

By calculating the target object distance G in step S11, the position of the pin center Pk in a depth direction of the optical images 81 and 82 is obtained. The position of the pin center Pk in the planar directions (the right-and-left direction and the up/down direction) of the optical images 81 and 82 is already known at the time of acquiring the optical images 81 and 82 in which the pin center Pk appears. The three-dimensional position of each component constituting the imaging unit 55A and the imaging unit 55B is known in advance. Thus, by calculating the target object distance G, the three-dimensional position of the pin center Pk with respect to the imaging unit 55 can be obtained.

By calculating the advanced distance K1 in step S4, information on the three-dimensional position of the hand center Dt with reference to the imaging unit 55 can be calculated as the three-dimensional information S (see FIG. 12B). By calculating the advanced distance K2 in step S7, information on the three-dimensional position of the hand center Ds with reference to the imaging unit 55 can also be calculated. Thus, the information on the three-dimensional position of the pin center Pk with reference to the hand center Ds can be calculated based on the information on the three-dimensional position of the hand center Ds with reference to the imaging unit 55 and the three-dimensional position of the pin center Pk with reference to the imaging unit 55. That is, the position calculation unit 73 calculates, as the necessary moving amount E, information on the moving amount estimated to be necessary for movement to the pin center Pk, which is the target position, starting from the hand center Ds.

The information of the necessary moving amount E corresponds to information for specifying the three-dimensional position of the substrate placement unit PS1, which is the conveyance target object. That is, the position calculation unit 73 calculates the information of the necessary moving amount E as the target object positional information. When the position calculation unit 73 has calculated the target object distance G and the necessary moving amount E, step S11 is completed. Step S11 corresponds to a target object position calculation step.

As illustrated in FIG. 19B, the necessary moving amount E corresponds to information on the distance to the pin center Pk with reference to the hand center Ds. The necessary moving amount E includes three components of a distance Ex in the x direction, a distance Ey in the y direction, and a distance Ez in the z direction. That is, when the information of the necessary moving amount E is obtained based on the image data captured by the imaging unit 55, and the moving distance in the x direction is the distance Ex, the moving distance in the y direction is the distance Ey, and the moving distance in the z direction is the distance Ez with the hand center Ds as a starting point, it is assumed that the position of the hand center Ds shifts to the position of the pin center Pk which is the target position.

Here, as a result of intensive studies by the inventors of the present invention, it has been found that a difference may be generated between the value of the movement distance instructed by the control unit 65 to the substrate conveyance mechanism TM1 and the value of the movement distance of the substrate conveyance mechanism TM1 estimated from the image captured by the imaging unit 55. As a specific numerical value, there is a case where the moving distance (estimated moving amount) of the advance/retraction drive unit 44 calculated by the position calculation unit 73 based on the optical images 81 and 82 captured by the pair of imaging units 55 is 102 mm, although the drive control unit 71 of the control unit 65 has instructed the advance/retraction drive unit 44 to move by 100 mm in the R1 direction. As a cause of the difference between the movement distance instructed by the control unit 65 and the movement distance calculated from the image data, deterioration of a component in the hand unit 43, a defect of a component connecting the hand unit 43 and the advance/retraction drive unit 44, a positional deviation of the imaging unit 55, a coordinate deviation of the optical images 81 and 82, a parameter error in the control system, and the like can be considered. When the hand unit 43 and the advance/retraction drive unit 44 are connected by a belt, examples of a defect of a component connecting the hand unit 43 and the advance/retraction drive unit 44 include tear of the belt, deviation of a pulley, and the like. When the hand unit 43 and the advance/retraction drive unit 44 are connected by a gear, examples of the defect include backlash and disengagement of the gear.

In this manner, the value (as an example, the advancing amount P1) instructed as the moving distance by the control unit 65 to the hand unit 43 may be different from the value (as an example, the estimated moving amount L1) estimated as the moving distance of the hand unit 43 from the image data. The value instructed as the movement distance to the hand unit 43 by the control unit 65 may be different from the value of the distance that the hand unit 43 actually moves in the real space because of deterioration of components of the substrate conveyance mechanism TM1 or the like. In addition, the value estimated as the movement distance of the hand unit 43 from the image data may be different from the value of the distance that the hand unit 43 actually moves in the real space. Thus, it has been found that when the substrate conveyance mechanism TM1 is moved from the advanced position Cs according to the necessary moving amount E obtained based on the image data obtained by the imaging unit 55, a difference may be generated between the position where the substrate conveyance mechanism TM1 actually moves according to the instruction of the control unit 65 to move according to the necessary moving amount E and the position calculated by the position calculation unit 73 as the target position. Thus, in the substrate conveyance apparatus 10 according to Example, steps S12 and S13 are performed, and the necessary moving amount E is calibrated using the calibration unit 75, whereby teaching of the position of the conveyance target object is more accurately performed. Hereinafter, step S12 and step S13 will be described.

Step S12 (Calibration of target object positional information)

When the position calculation unit 73 has calculated the necessary moving amount E, step S12 of calibrating the necessary moving amount E which is the target object positional information starts. When step S12 is started, the information of the necessary moving amount E calculated in step S12 is transmitted to the calibration unit 75. The calibration unit 75 calibrates the necessary moving amount E using the information of the correction coefficient Mk already transmitted from the correction coefficient calculation unit 74.

When the advancing amount P1 is equal to the estimated moving amount L1, the moving distance instructed by the control unit 65 is equal to the moving distance calculated from the image data. As an example, when the necessary moving amount E is "Ex = 800 mm, Ey = Ez = 0 mm", the substrate conveyance mechanism TM1 accurately reaches the target position (pin center Pk) by moving the "distance estimated to be 800 mm from the image data of the optical images 81 and 82" in the x direction.

Then, when the advancing amount P1 is equal to the estimated moving amount L1, the control unit 65 instructs the substrate conveyance mechanism TM1 to "move 800 mm in the x direction", so that the distance that the substrate conveyance mechanism TM1 actually moves is the "distance estimated to be 800 mm from the image data of the optical images 81 and 82". That is, when the advancing amount P1 is equal to the estimated moving amount L1, the control unit 65 controls the moving direction and the moving distance of the substrate conveyance mechanism TM1 according to the content of the necessary moving amount E, and thus the substrate conveyance mechanism TM1 accurately reaches the target position. Thus, when the advancing amount P1 is equal to the estimated moving amount L1, it is not necessary to calibrate the position calculation unit 73.

On the other hand, when the advancing amount P1 is different from the estimated moving amount L1, the moving distance instructed by the control unit 65 is different from the moving distance calculated from the image data. In this case, when the control unit 65 controls the moving direction and the moving distance of the substrate conveyance mechanism TM1 according to the necessary moving amount E, the substrate conveyance mechanism TM1 reaches a position deviated from the target position. As an example, when the necessary moving amount E is "Ex = 800 mm, Ey = Ez = 0 mm", the advancing amount P1 is 100 mm, and the estimated moving amount L1 is 101 mm, that is, the value of the moving distance of the substrate conveyance mechanism TM1 calculated from the image data is larger than the value of the distance for which the control unit 65 instructs the substrate conveyance mechanism TM1 to move. That is, when the control unit 65 instructs the substrate conveyance mechanism TM1 to "move 800 mm in the x direction" in accordance with the information of the necessary moving amount E, the distance by which the substrate conveyance mechanism TM1 actually moves becomes larger than the "distance estimated to be 800 mm from the image data of the optical images 81 and 82". In other words, the distance that the substrate conveyance mechanism TM1 actually moves is larger than the movement distance necessary for accurately reaching the target position. In other words, when the control unit 65 instructs the substrate conveyance mechanism TM1 to "move by 800 mm in the x direction" according to the information of the necessary moving amount E, the distance that the substrate conveyance mechanism TM1 moves on the image data captured by the imaging unit 55 becomes larger than 800 mm.

That is, when the estimated moving amount L1 is larger than the advancing amount P1, if the control unit 65 gives an instruction to move the hand unit 43 according to the necessary moving amount E, a distance Fh that the hand unit 43 actually moves becomes larger than the necessary moving amount E. As a result, as illustrated in FIG. 20, the substrate conveyance mechanism TM1 moves to a position Pf beyond the pin center Pk. On the other hand, when the estimated moving amount L1 is smaller than the advancing amount P1, if the control unit 65 gives an instruction to move the hand unit 43 according to the necessary moving amount E, the distance Fh that the hand unit 43 actually moves becomes smaller than the necessary moving amount E. As a result, the substrate conveyance mechanism TM1 moves to a position short of the pin center Pk.

In this manner, when the advancing amount P1 is different from the estimated moving amount L1, and the control unit 65 controls the substrate conveyance mechanism TM1 according to the information of the necessary moving amount E, the substrate conveyance mechanism TM1 reaches the position Pf deviated from the pin center Pk which is the target position. Thus, when the advancing amount P1 and the estimated moving amount L1 are different, the position calculation unit 73 is calibrated by the calibration unit 75.

The calibration unit 75 calibrates the information of the necessary moving amount E calculated by the position calculation unit 73 such that the advancing amount P1 matches the estimated moving amount L1. That is, when the calibration unit 75 calibrates the position calculation unit 73, the moving amount necessary for moving the hand unit 43 of the substrate conveyance mechanism TM1 to the target position is calculated as the calibrated moving amount H.

As an overview, the calibrated moving amount H is calculated using the following mathematical expression (D) based on the values of the necessary moving amount E, the advancing amount P1, and the estimated moving amount L1. That is, the calibrated moving amount H is calculated by integrating the correction coefficient Mk with the necessary moving amount E. In other words, the calibrated moving amount H is calculated by dividing the product of the necessary moving amount E and the advancing amount P1 by the estimated moving amount L1.

$$H = E \cdot Mk = (E \cdot P1)/L1 \quad \ldots\ldots \quad (D)$$

Specifically, the calibrated moving amount H includes three components of a distance Hx in the x direction, a distance Hy in the y direction, and a distance Hz in the z direction. That is, when the control unit 65 instructs the substrate conveyance mechanism TM1 to "move by the distance Hx in the x direction, move by the distance Hy in the y direction, and move by the distance Hz in the z direction with the hand center Ds as a starting point", the substrate conveyance mechanism TM1 accurately shifts from the hand center Ds to the target position (pin center Pk).

The value of the distance Hx in the x direction in the calibrated moving amount H is calculated based on the advancing amount P1, the estimated moving amount L1, and the value of the distance Ex in the x direction in the necessary moving amount E by using the following mathematical expression (E).

$$Hx = Ex \cdot Mk = (Ex \cdot P1)/L1 \quad \ldots\ldots \quad (E)$$

As shown in the mathematical expression (E), the product of the distance Ex in the x direction in the necessary moving amount E and the advancing amount P1 is divided by the estimated moving amount L1, whereby the distance Hx in the x direction in the calibrated moving amount H is calculated.

The value of the distance Hy in the y direction in the calibrated moving amount H is calculated based on the advancing amount P1, the estimated moving amount L1, and the value of the distance Ey in the y direction in the necessary moving amount E using the following mathematical expression (F).

$$Hy = Ey \cdot Mk = (Ey \cdot P1)/L1 \quad \ldots\ldots \quad (F)$$

As shown in the mathematical expression (F), the product of the distance Ey in the y direction in the necessary moving amount E and the advancing amount P1 is divided by the estimated moving amount L1, whereby the distance Hy in the y direction in the calibrated moving amount H is calculated.

The value of the distance Hz in the z direction in the calibrated moving amount H is calculated based on the advancing amount P1, the estimated moving amount L1, and the value of the distance Ez in the z direction in the necessary moving amount E using the following mathematical expression (G).

$$Hz = Ez \cdot Mk = (Ez \cdot P1)/L1 \quad \ldots\ldots \quad (G)$$

As shown in the mathematical expression (G), the product of the distance Ey in the y direction in the necessary moving amount E and the advancing amount P1 is divided by the estimated moving amount L1, whereby the distance Hy in the y direction in the calibrated moving amount H is calculated. Thus, the calibration unit 75 calibrates the necessary moving amount E using the correction coefficient Mk. In other words, the calibration unit 75 calibrates the necessary moving amount E to the calibrated moving amount H based on the values of the advancing amount P1 and the estimated moving amount L1. Specifically, the calibration unit 75 calculates the calibrated moving amount H by calculating the components Hx, Hy, and Hz of the calibrated moving amount H. The calibrated moving amount H corresponds to the corrected positional information in the present invention. The corrected positional information corresponds to target object positional information calibrated by the correction coefficient. Step S12 is completed when the calibrated moving amount H has been calculated. Step S12 corresponds to the calibration step in the present invention.

Step S13 (Storing of corrected positional information)

The calibrated moving amount H corresponds to a moving amount of the hand unit 43 necessary for the hand unit 43 to move from the current position (here, the advanced position Cs) to the accurate target position. That is, by calculating the calibrated moving amount H, the accurate position of the conveyance target object is specified for each of the three-dimensional directions.

The value of the calibrated moving amount H calculated by the calibration unit 75 is stored in the position storage unit 76. That is, by storing the value of the calibrated moving amount H, teaching of accurate positional information of the conveyance target object is performed to the substrate conveyance apparatus 10 (teaching step). That is, the calibration unit 75 calculates an accurate target position Js of the hand unit 43. That is, when the control unit 65 issues an instruction to move the substrate conveyance mechanism TM1 by the distance Hx in the x direction, move the substrate conveyance mechanism TM1 by the distance Hy in the y direction, and move the substrate conveyance mechanism TM1 by the distance Hz in the z direction in a state where the hand unit 43 is at the advanced position Cs, the calibration unit 75 calculates that the position where the substrate conveyance mechanism TM1 moves is the target position Js.

When the substrate conveyance mechanism TM1 is moved to the target position Js of the conveyance target object, the control unit 65 reads the calibrated moving amount H from the position storage unit 76. Then, the control unit 65 transmits a control signal to perform movement according to the calibrated moving amount H to the advance/retraction drive unit 44, the rotary drive unit 45, the first moving mechanism 47, the second moving mechanism 48, and the like disposed in the substrate conveyance mechanism TM1.

That is, when the hand unit 43 is moved from the advanced position Cs to the target position Js, the control unit 65 instructs the substrate conveyance mechanism TM1 to match the moving distance and the moving direction with the calibrated moving amount H. That is, the control unit 65 transmits a control signal to move the substrate conveyance mechanism TM1 by the distance Hx in the x direction, by the distance Hy in the y direction, and by the distance Hz in the z direction. Specifically, when the hand unit 43 is moved from the advanced position Cs to the target position Js, the control unit 65 controls the substrate conveyance mechanism TM1 to move the hand center D of the hand unit 43 by the distance Hx in the x direction, by the distance Hy in the y direction, and by the distance Hz in the z direction with the hand center Ds as a starting point. As the hand unit 43 moves from the advanced position Cs to the target position Js, the hand center D of the hand unit 43 accurately shifts from the position of the hand center Ds to the pin center Pk. When the control unit 65 transmits an instruction to move the substrate conveyance mechanism TM1 according to the calibrated moving amount H, the moving amount of the substrate conveyance mechanism TM1 calculated (estimated) from the image data is the necessary moving amount E.

The calibrated moving amount H is a value calibrated from the necessary moving amount E according to the difference between the advancing amount P1 of the control unit 65 and the estimated moving amount L1 calculated from the image data. That is, when the control unit 65 controls the substrate conveyance mechanism TM1 to move the substrate conveyance mechanism TM1 according to the calibrated moving amount H, the distance Fh by which the substrate conveyance mechanism TM1 actually moves is equal to the necessary moving amount E. Thus, when the control unit 65 performs the movement control according to the calibrated moving amount H, the substrate conveyance mechanism TM1 moves by the distance Ex in the x direction, moves by the distance Ey in the y direction, and moves by the distance Ez in the z direction according to the control of the drive control unit 71. As a result, the hand unit 43 shifts its position such that the hand center D accurately coincides with the pin center Pk. When the calibrated moving amount H is stored in the position storage unit 76, and teaching of the target position Js is performed, step S13 is completed. When the processing up to step S13 is completed, a series of steps performed by the substrate conveyance apparatus 10 is completed.

Thereafter, the substrate conveyance apparatus 10 can teach the target position of each conveyance target object to the substrate conveyance mechanism TM1 by repeating steps S1 to S13 for each conveyance target object. When the teaching is performed for the second and subsequent conveyance target object, the correction coefficient Mk is already calculated when the teaching is performed for the first conveyance target object. Thus, when the teaching is performed for the second and subsequent conveyance target objects, the correction coefficient Mk may be used as the calibrated moving amount H. That is, when teaching of the same substrate conveyance mechanism on the positions of the plurality of conveyance target objects are continuously performed, the processing from step S1 to step S9 can be omitted in the teaching work on the second and subsequent conveyance target objects.

Teaching of the target position of each conveyance destination is performed to the substrate conveyance mechanisms TR1 to TR5 in addition to the substrate conveyance mechanism TM1. When the substrate conveyance mechanism is different, deterioration states of the hand unit 43, the imaging unit 55, and the like are different. Thus, when teaching of the position of the conveyance target object is performed on a new substrate conveyance mechanism, it is necessary to newly calculate the correction coefficient Mk by performing steps S1 to S9. By performing teaching of the target position of the conveyance destination to all the substrate conveyance mechanisms, teaching with the substrate conveyance apparatus 10 is completed for the entire substrate processing apparatus 1.

Step S14 (Activation of notification unit)

Here, the operation of the substrate processing apparatus 1 in a case where the option Q1 illustrated in FIG. 7 is "Yes" will be described. When the estimated moving amount L1 calculated in step S7 is significantly different from the predetermined advancing amount P1, it is determined that a situation requiring maintenance of the substrate processing apparatus 1 has occurred. That is, when the estimated moving amount L1 is significantly larger than the advancing amount P1 or when the estimated moving amount L1 is significantly smaller than the advancing amount P1, there is a high possibility that a trouble has occurred in the substrate processing apparatus 1. As an example, when the deterioration of the component that drives the hand unit 43 has increased, when the disposition of the imaging unit 55 is greatly deviated from the estimated position, or when the deviation of the coordinates of the optical images 81 and 82 captured by the imaging unit 55 is large, a situation in which the estimated moving amount L1 is significantly different from the advancing amount P1 occurs. When the teaching is performed by the substrate conveyance apparatus 10 in a state where the estimated moving amount L1 is significantly different from the advancing amount P1, it is difficult to improve the accuracy of the teaching.

Thus, in Example, the notification unit 77 is appropriately operated according to the difference between the advancing amount P1 and the estimated moving amount L1. That is, when step S9 is completed, the control unit 65 calculates the absolute value ($|P1-L1|$) of the difference between the advancing amount P1 and the estimated moving amount L1, and compares the absolute value with the threshold P2. When the absolute value ($|P1 - L1|$) is equal to or more than the threshold P2, the processing proceeds from step S9 to step S14.

When step S14 is started, the control unit 65 activates the notification unit 77. The notification unit 77 generates a warning sound, light, or the like to notify the operator of information indicating that the absolute value of the difference between the advancing amount P1 and the estimated moving amount L1 has increased to a value equal to or more than the threshold P2. As another example of the configuration in which the notification unit 77 notifies the information, characters or images suggesting that the absolute value of the difference between the advancing amount P1 and the estimated moving amount L1 has increased to a value equal to or more than the threshold P2 may be displayed on the display unit included in the operation unit 67.

When the notification unit 77 notifies the information, the operator can quickly know that the absolute value of the difference between the advancing amount P1 and the estimated moving amount L1 has increased to a value equal to or more than the threshold P2, and the maintenance of the substrate processing apparatus 1 needs to be performed. When the operator has obtained the information from the notification unit 77, the operator executes an operation to stop the substrate processing apparatus 1 and performs maintenance of the drive system of the hand unit 43, the imaging unit 55, or the like, as an example. After performing the maintenance of the substrate processing apparatus 1, the operator resumes the operation of the substrate processing apparatus 1. By performing maintenance of the substrate processing apparatus 1 at an appropriate timing based on the difference between the advancing amount P1 and the estimated moving amount L1, it is possible to quickly avoid a degradation in the accuracy of teaching performed by the substrate conveyance apparatus 10.

<Effects of Configuration of Example>

The substrate conveyance apparatus 10 according to Example includes a pair of imaging units 55. The pair of imaging units 55 is disposed at a predetermined interval. The pair of imaging units 55 captures optical images 81 and 82 of a region including the hand unit 43 and a space in front of the hand unit 43. The pair of imaging units 55 is disposed on both sides of the substrate conveyance apparatus TM. Thus, based on the parallax Nd between the first optical image 81 acquired by one imaging unit 55A and the second optical image 82 acquired by the other imaging unit 55B, the position calculation unit 73 can calculate the distance from the imaging unit 55 to the subject of imaging as the relative distance K also in the depth direction of the optical images 81 and 82. Thus, the position calculation unit 73 can calculate three-dimensional position information for the subject of imaging appearing in the optical images 81 and 82. That is, the position calculation unit 73 can calculate the three-dimensional positional information of each of the hand unit 43, the substrate placement unit PS1, and the like appearing in the optical images 81 and 82.

The position calculation unit 73 extracts feature points from the images of the subject of imaging appearing in the optical images 81 and 82, and specifies a reference point of the subject of imaging based on the positions of the feature points. Then, the position calculation unit 73 calculates the distance from the imaging unit 55 to the subject of imaging based on the reference point of the subject of imaging. That is, since the three-dimensional positional information of the subject of imaging is calculated using the feature point of the subject of imaging, in Example using the substrate conveyance apparatus 10, the work of placing the teaching member such as a simulated substrate onto the subject of imaging is unnecessary. That is, since it is possible to omit work that is difficult to automate, such as installing the teaching member onto the conveyance destination, it is possible to simplify the configuration of the substrate conveyance apparatus 10 and to automate the teaching work using the substrate conveyance apparatus 10.

The position calculation unit 73 calculates the estimated moving amount L1 of the hand unit 43 based on the pair of optical images 81A and 82A and the pair of optical images 81B and 82B. The pair of optical images 81A and 82A are images obtained by capturing images of the hand unit 43 moved to the reference position Bs by the pair of imaging units 55. The pair of optical images 81B and 82B are images obtained by capturing images of the hand unit 43 moved to the advanced position Cs by the pair of imaging units 55. The advanced position Cs corresponds to a position advanced from the reference position Bs in the R direction by the predetermined advancing amount P1.

Each of the imaging units 55 is disposed in the substrate conveyance apparatus TM1 so as not to move with the movement of the hand unit 43. That is, even when the hand unit 43 advances in the R directions, each of the imaging units 55 does not shift its position. Thus, the position of the substrate holding unit appearing in the pair of optical images 81A and 82A is different from the position of the substrate holding unit appearing in the pair of optical images 81B and 82B. Thus, the position calculation unit can calculate the estimated moving amount L1 of the hand unit 43 on the image according to the distance between the position of the hand unit 43 appearing in the optical images 81A and 82A and the position of the hand unit 43 appearing in the optical images 81B and 82B. The estimated moving amount L1 corresponds to a value estimated as the moving distance of the substrate conveyance mechanism TM1 from the data of the optical images 81 and 82 when the control unit 65 instructs the substrate conveyance mechanism TM1 to move by the advancing amount P1.

The substrate conveyance apparatus 10 according to Example includes the correction coefficient calculation unit 74 that calculates the correction coefficient Mk and the calibration unit 75 that calibrates the necessary moving amount E calculated by the position calculation unit 73. The position calculation unit 73 calculates the necessary moving amount E based on the optical images 81C and 82C in which the substrate placement unit PS1, which is the conveyance target object, appears. The correction coefficient calculation unit 74 calculates the correction coefficient Mk based on the advancing amount P1 and the estimated moving amount L1. The calibration unit 75 calibrates the information of the necessary moving amount E calculated by the position calculation unit 73 based on the correction coefficient Mk. With this calibration, the difference between the value of the distance indicated by the control unit 65 as the distance for moving the hand unit 43 and the value of the distance that the hand unit 43 moves in the optical images 81 and 82 acquired by the imaging unit 55 is calibrated.

The position calculation unit 73 calculates information on the three-dimensional distance E for the hand unit 43 to move to the target position Js using the optical images 81C and 82C acquired by the pair of imaging units 55 capturing images of the substrate placement unit PS1 as a conveyance destination with the imaging unit 55. However, the value of the three-dimensional distance E is affected by the difference between the distance value instructed by the control unit 65 and the distance value calculated from the optical images 81 and 82. Thus, the calibrated moving amount H is calculated by the calibration unit 75 calibrating the value of the three-dimensional distance E so that the estimated moving amount L1 and the advancing amount P1 match each other.

The calibrated moving amount H is a value obtained by excluding the influence of the difference between the distance value instructed by the control unit 65 and the distance value calculated from the optical images 81 and 82 from the value of the three-dimensional distance E. That is, by performing control to move the hand unit 43 according to the calibrated moving amount H, the hand unit 43 can be accurately moved to the target position Js. In this manner, in the configuration in which the three-dimensional positions of the hand unit 43 and the conveyance destination are specified based on the images 81 and 82 captured by the imaging unit 55 and teaching of the target position Js is performed, the influence of the difference caused by the images 81 and 82 can be eliminated by performing the calibration with the calibration unit 75. As a result, the accuracy of the information taught by the teaching unit 75 can be further improved.

In Example, when the absolute value of the difference between the estimated moving amount L1 and the advancing amount P1 is equal to or more than the threshold P2, the notification unit 77 is activated. The notification unit 77 notifies the operator of information indicating that the absolute value of the difference between the estimated moving amount L1 and the advancing amount P1 is equal to or more than the threshold P2. With the notification unit 77 notifying the information, the operator can quickly know that the maintenance of the substrate processing apparatus 1 needs to be performed. When the operator has obtained the information from the notification unit 77, the operator executes an operation to stop the substrate processing apparatus 1 and performs maintenance of the drive system of the hand unit 43, the imaging unit 55, or the like, as an example. After performing the maintenance of the substrate processing apparatus 1, the operator resumes the operation of the substrate processing apparatus 1. By performing maintenance of the substrate processing apparatus 1 at an appropriate timing based on the difference between the advancing amount P1 and the estimated moving amount L1, it is possible to quickly avoid a degradation in the accuracy of teaching performed by the substrate conveyance apparatus 10.

In Example, the imaging unit 55 that captures an optical image of the conveyance target object is mounted on the substrate conveyance mechanism TM1. That is, when teaching of the positions of a large number of conveyance target object to the single substrate conveyance mechanism TM1 is performed, it is possible to accurately perform the teaching of the positional information of the large number of conveyance target objects by using the pair of imaging units 55 mounted on the substrate conveyance mechanism TM1. That is, since it is not necessary to dispose a large number of imaging units 55 in the substrate processing apparatus 1 in such a manner as to correspond to each of a large number of conveyance target objects, the number of imaging units 55 can be greatly reduced.

The present invention is not limited to the above embodiments, and can be modified as follows.

(1) In the above-described Example, a case where the pair of optical images 81 and 82 used for calculating the relative distance K of the hand unit 43 and the pair of optical images 81 and 82 used for calculating the target object distance G of the substrate placement unit PS1 are different images has been described as an example. However, the relative distance K of the hand unit 43 and the target object distance G of the substrate placement unit PS1 may be calculated using the same optical images 81 and 82.

That is, as an example, the first optical image 81D and the second optical image 81D as illustrated in FIG. 22 are acquired. Each of the first optical image 81D and the second optical image 81D is an optical image in which the hand unit 43 moved to the reference position Bs and the substrate placement unit PS1 appear. The position calculation unit 73 can calculate the reference distance K1 of the hand unit 43 at the reference position Bs using the first optical image 81D and the second optical image 81D. The position calculation unit 73 can calculate the target object distance G of the substrate placement unit PS1 using the first optical image 81D and the second optical image 81D. In such a modification, since the number of times of capturing the optical images 81 and 82 can be reduced, the time required for the teaching work can be shortened.

(2) In each of the above-described examples, the timing of executing step S10 and step S11 is not limited to after step S9 is completed. As an example, the target object distance G may be calculated by executing steps S10 to S11 before executing step S3. As another example, the target object distance G may be calculated by executing steps S10 to S11 before executing the step of step S6.

(3) In each of the above-described examples, the substrate conveyance mechanism TM1 includes one hand unit 43, but it may include two or more hand units 43. Similarly, the substrate conveyance mechanisms TR1 to TR5 include one hand 13, but they may include two or more hands 13.

(4) In each of the above-described examples, the hand center D, which is the center of the hand unit 43 in Example, is set as the reference point of the hand unit 43 (see FIG. 5B). A portion other than the hand center D may be defined as the reference point of the hand unit 43. As an example, any one of the suction units 53 included in the hand unit 43 may be used as the reference point of the hand unit 43. As another example, the midpoint between the two tips 50 of the hand unit 43 may be used as the reference point of the hand unit 43.

(5) In each of the above-described examples, the configuration and the number of the blocks included in the substrate processing apparatus 1 may be appropriately changed. As an example, one or more blocks among the coating block 3, the development block 4, the IF block 5, and the exposure device EXP may be omitted according to the purpose of the substrate processing apparatus 1.

**Claims**

1. A substrate conveyance apparatus that conveys a substrate to a conveyance target object, the substrate conveyance apparatus comprising:

   a substrate holding unit movable in a first direction while holding a substrate;
   a movable table that holds the substrate holding unit and is movable at least in a second direction different from the first direction;
   a pair of imaging units disposed on the movable table at a predetermined interval and configured to capture an image of a region including the substrate holding unit and a space in front of the substrate holding unit;
   an advance/retraction drive unit that drives the substrate holding unit to advance or retract in the first direction;
   a drive control unit that transmits information on a drive distance in the first direction to the advance/retraction drive unit to control an operation of the advance/retraction drive unit;
   a reference image acquisition unit that acquires a reference image by capturing an image of the substrate holding unit disposed at a reference position in the substrate conveyance apparatus with the pair of imaging units;
   an advanced image acquisition unit that acquires an advanced image by capturing, with the pair of imaging units, an image of the substrate holding unit advanced from the reference position in the first direction by a predetermined advancing amount by the drive control unit;
   a target object image acquisition unit that acquires a target image by capturing an image of the conveyance target object with the pair of imaging units;
   a reference position calculation unit that calculates a position of the substrate holding unit with respect to the pair of imaging units as reference positional information based on the reference image;
   an advanced position calculation unit that calculates a position of the substrate holding unit with respect to the pair of imaging units as advanced positional information based on the advanced image;

a target object position calculation unit that calculates a position of the conveyance target object with respect to the pair of imaging units as target object positional information based on the target object image;

an estimated moving amount calculation unit that calculates an estimated moving amount that is a distance by which the substrate holding unit is estimated to have moved from the reference position to the advanced position based on the reference positional information and the advanced positional information;

a correction coefficient calculation unit that calculates a correction coefficient for correcting a difference between the estimated moving amount and the advancing amount by using the estimated moving amount and the advancing amount;

a calibration unit that acquires corrected positional information by calibrating the target object positional information using the correction coefficient; and

a position storage unit that stores the corrected positional information acquired by the calibration unit, wherein

the pair of imaging units

move with movement of the movable table but do not move with movement of the substrate holding unit.

2. The substrate conveyance apparatus according to claim 1, wherein

the first direction is a horizontal direction,
the second direction is an up/down direction, and
the movable table is
movable at least in the up/down direction and rotatable around an axis in the up/down direction.

3. The substrate conveyance apparatus according to claim 1, further comprising
a notification unit that notifies, when a difference between the estimated moving amount and the advancing amount has a value equal to or more than a predetermined value, information indicating that the difference between the estimated moving amount and the advancing amount has a value equal to or more than a predetermined value.

4. A position teaching method for teaching a position of a conveyance target object to a substrate conveyance apparatus that conveys a substrate to the conveyance target object, the substrate conveyance apparatus including:

a substrate holding unit movable in a first direction while holding a substrate;
a movable table that holds the substrate holding unit and is movable at least in a second direction different from the first direction;
a pair of imaging units disposed on the movable table at a predetermined interval in such a manner as to move with movement of the movable table but not with movement of the substrate holding unit, the pair of imaging units being configured to capture an image of a region including the substrate holding unit and a space in front of the substrate holding unit;
an advance/retraction drive unit that drives the substrate holding unit to advance or retract in the first direction; and
a drive control unit that transmits information on a drive distance in the first direction to the advance/retraction drive unit to control an operation of the advance/retraction drive unit,
the method comprising:

a reference image acquisition step of acquiring a reference image by capturing an image of the substrate holding unit disposed at a reference position in the substrate conveyance apparatus with the pair of imaging units;
a reference distance calculation step of calculating a position of the substrate holding unit with respect to the pair of imaging units as reference positional information based on the reference image;
an advanced image acquisition step of acquiring an advanced image by capturing, with the pair of imaging units, an image of the substrate holding unit advanced from the reference position in the first direction by a predetermined advancing amount by the drive control unit;
an advanced distance calculation step of calculating the position of the substrate holding unit with respect to the pair of imaging units as advanced positional information based on the advanced image;
an estimated moving amount calculation step of calculating an estimated moving amount that is a distance by which the substrate holding unit is estimated to have moved from the reference position to the advanced position based on the reference positional information and the advanced positional information;
a correction coefficient calculation step of calculating a correction coefficient for correcting a difference between the estimated moving amount and the advancing amount by using the estimated moving amount and the advancing amount;

a target object image acquisition step of acquiring a target object image by capturing an image of the conveyance target object with the pair of imaging units;

a target object position calculation step of calculating a position of the conveyance target object with respect to the pair of imaging units as target object positional information based on an image of the conveyance target object image captured by the pair of imaging unit;

a calibration step of acquiring corrected positional information by calibrating the target object positional information using the correction coefficient; and

a teaching step of teaching the corrected positional information acquired in the calibration step as the position of the conveyance target object.

5. The position teaching method according to claim 4, further comprising a notification step of notifying, when a difference between the estimated moving amount calculated in the estimated moving amount calculation step and the advancing amount has a value equal to or more than a predetermined value, information that the difference between the estimated moving amount and the advancing amount has a value equal to or more than a predetermined value.

Fig.1

Fig.2

# Fig.3

EP 4 716 441 A1

Fig.4a

Fig.4b

Fig.4c

Fig.5a

Fig.5b

Fig.5c

EP 4 716 441 A1

**Fig.6**

Fig.6 — SUBSTRATE CONVEYANCE APPARATUS (1), SUBSTRATE CONVEYANCE MECHANISM (TM1, 10): HAND UNIT (43), ADVANCE/RETRACTION DRIVE UNIT (44), IMAGING UNIT (55): CAMERA (59), IMAGE ACQUISITION UNIT (61), COMMUNICATION UNIT (63); CONTROL UNIT (65): DRIVE CONTROL UNIT (71), POSITION CALCULATION UNIT (73), CORRECTION COEFFICIENT CALCULATION UNIT (74), POSITION STORAGE UNIT (76), CALIBRATION UNIT (75); NOTIFICATION UNIT (77), STORAGE UNIT (69), OPERATION UNIT (67).

Fig.7

```
                    ( START )
                        │
    ┌───────────────────────────────────────┐
    │   MOVE  SUBSTRATE  CONVEYANCE          │ ～S1
    │             MECHANISM                  │
    └───────────────────────────────────────┘
                        │
    ┌───────────────────────────────────────┐
    │      MOVE  TO  REFERENCE  POSITION     │ ～S2
    └───────────────────────────────────────┘
                        │
    ┌───────────────────────────────────────┐
    │   CAPTURE  IMAGE  OF  HAND  UNIT  AT   │ ～S3
    │          REFERENCE  POSITION           │
    └───────────────────────────────────────┘
                        │
    ┌───────────────────────────────────────┐
    │     CALCULATE  REFERENCE  DISTANCE     │ ～S4
    └───────────────────────────────────────┘
                        │
    ┌───────────────────────────────────────┐
    │       MOVE  TO  ADVANCED  POSITION     │ ～S5
    └───────────────────────────────────────┘
                        │
    ┌───────────────────────────────────────┐
    │   CAPTURE  IMAGE  OF  HAND  UNIT  AT   │ ～S6
    │           ADVANCED  POSITION           │
    └───────────────────────────────────────┘
                        │
    ┌───────────────────────────────────────┐
    │     CALCULATE  ADVANCED  DISTANCE      │ ～S7
    └───────────────────────────────────────┘
                        │
    ┌───────────────────────────────────────┐
    │   CALCULATE  ESTIMATED  MOVING  AMOUNT │ ～S8
    └───────────────────────────────────────┘
                        │
    ┌───────────────────────────────────────┐
    │   CALCULATE  CORRECTION  COEFFICIENT   │ ～S9
    └───────────────────────────────────────┘
                        │
  Q1                                    Yes    ┌──────────────────────┐
     ⟨  |P1 – L1|  ≥  P2?  ⟩────────────────→  │      ACTIVATE        │ ～S14
                        │                       │  NOTIFICATION UNIT   │
                       No                       └──────────────────────┘
                        │←──────────────────────────────┘
    ┌───────────────────────────────────────┐
    │   CAPTURE  IMAGE  OF  CONVEYANCE       │ ～S10
    │          TARGET  OBJECT                │
    └───────────────────────────────────────┘
                        │
    ┌───────────────────────────────────────┐
    │     CALCULATE  TARGET  OBJECT          │ ～S11
    │       POSITIONAL  INFORMATION          │
    └───────────────────────────────────────┘
                        │
    ┌───────────────────────────────────────┐
    │     CALIBRATE  TARGET  OBJECT          │ ～S12
    │       POSITIONAL  INFORMATION          │
    └───────────────────────────────────────┘
                        │
    ┌───────────────────────────────────────┐
    │   STORE  CORRECTED  POSITIONAL         │ ～S13
    │          INFORMATION                   │
    └───────────────────────────────────────┘
                        │
                    (  END  )
```

Fig.8a

Fig.8b

Fig.9a

Fig.9b

# Fig.10

81(81A)

82(82A)

43
50
49

50
43
49

# Fig.11a

# Fig.11b

Dt(DtL)

53          53

53

81(81A)

Dt(DtR)

53          53

53

82(82A)

# Fig.11c

81A(82A)

DtR          DtL

Nd

Fig.12a

Fig.12b

Fig.13a

Fig.13b

Fig.14

81(81B)    82(82B)

43
50
49

50    43
49

Fig.15a    Fig.15b

Ds(DsL)
53    53
53
Dt(DtL)
L1

Ds(DsR)
53    53
L1
53
Dt(DtR)

81(81B)    82(82B)

Fig.15c

81B(82B)

DsR    DsL

Nd

Fig.16a

Fig.16b

EP 4 716 441 A1

EP 4 716 441 A1

# Fig.17

# Fig.18a

# Fig.18b

# Fig.18c

44

Fig.19a

Fig.19b

## Fig.20

| TRANSMIT CONTROL SIGNAL TO MOVE ACCORDING TO NECESSARY MOVING AMOUNT E |

| P1<L1 |

| CONTROL UNIT | → | SUBSTRATE CONVEYANCE MECHANISM | ⇢ | Fh>E |

65          TM1

PS1
TM1
41
Cs
33
E
Dt
Pk
Ds 53
Pf
Fh
Bs
51
43
50
57
43
R1 R2
R

Y
x  z

# Fig.21

TRANSMIT CONTROL SIGNAL TO MOVE ACCORDING TO
CALIBRATED MOVING AMOUNT H

CONTROL UNIT — 65

SUBSTRATE CONVEYANCE MECHANISM — TM1

$Fh=E$

EP 4 716 441 A1

Fig.22

81(81D)                                    82(82D)

PS1                                              PS1
35          33                    35          33

43                                              43
50                                              50
49                                              49

## EUROPEAN SEARCH REPORT

**Application Number**

EP 25 19 0435

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | US 2018/218935 A1 (KUWAHARA JOJI [JP]) 2 August 2018 (2018-08-02) <br> * abstract; figures 1, 4, 5, 6 * <br> * paragraphs [0041] - [0047], [0113] * <br> * paragraphs [0101] - [0105], [0145] * <br> * paragraphs [0076] - [0077] * <br> ----- | 1-5 | INV. <br> H10P72/00 <br> H10P72/30 |
| A | US 2022/388785 A1 (ENOMOTO TADASHI [JP] ET AL) 8 December 2022 (2022-12-08) <br> * abstract; figures 2, 4-7 * <br> * paragraphs [0061] - [0070], [0092] - [0094] * <br> * paragraphs [0040] - [0042], [0131] * <br> ----- | 1-5 | |
| A | US 2022/254666 A1 (SADEGHI HOSSEIN [US] ET AL) 11 August 2022 (2022-08-11) <br> * abstract; figures 2, 9, 10 * <br> * paragraphs [0096], [0097] * <br> ----- | 1-5 | |

**TECHNICAL FIELDS SEARCHED (IPC)**

H10P

The present search report has been drawn up for all claims

| Place of search | Date of completion of the search | Examiner |
|---|---|---|
| The Hague | 13 January 2026 | Faderl, Ingo |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

.................................................................

& : member of the same patent family, corresponding document

EPO FORM 1503 03.82 (P04C01)

## EP 4 716 441 A1

### ANNEX TO THE EUROPEAN SEARCH REPORT
### ON EUROPEAN PATENT APPLICATION NO.

EP 25 19 0435

13-01-2026

| Patent document cited in search report | Publication date | Patent family member(s) | Publication date |
|---|---|---|---|
| US 2018218935 A1 | 02-08-2018 | CN 108364898 A | 03-08-2018 |
| | | JP 6842934 B2 | 17-03-2021 |
| | | JP 2018121007 A | 02-08-2018 |
| | | KR 20180088576 A | 06-08-2018 |
| | | TW 201828391 A | 01-08-2018 |
| | | US 2018218935 A1 | 02-08-2018 |
| US 2022388785 A1 | 08-12-2022 | CN 115440637 A | 06-12-2022 |
| | | JP 7648306 B2 | 18-03-2025 |
| | | JP 2022186429 A | 15-12-2022 |
| | | KR 20220164422 A | 13-12-2022 |
| | | TW 202249164 A | 16-12-2022 |
| | | US 2022388785 A1 | 08-12-2022 |
| US 2022254666 A1 | 11-08-2022 | CN 114466728 A | 10-05-2022 |
| | | CN 120663299 A | 19-09-2025 |
| | | JP 7660554 B2 | 11-04-2025 |
| | | JP 2022541346 A | 22-09-2022 |
| | | JP 2025108467 A | 23-07-2025 |
| | | KR 20220041171 A | 31-03-2022 |
| | | TW 202121565 A | 01-06-2021 |
| | | TW 202533364 A | 16-08-2025 |
| | | US 2022254666 A1 | 11-08-2022 |
| | | US 2025293063 A1 | 18-09-2025 |
| | | WO 2021022291 A1 | 04-02-2021 |

**REFERENCES CITED IN THE DESCRIPTION**

**Patent documents cited in the description**

- JP 2023 A
- JP 177092 A
- JP 2024058215 A
- JP 2023177092 A